(19) Europäisches Patentamt
European Patent Office
Office européen des brevets

(11) **EP 2 597 429 B1**

(12) **EUROPÄISCHE PATENTSCHRIFT**

(45) Veröffentlichungstag und Bekanntmachung des Hinweises auf die Patenterteilung:
**01.10.2014 Patentblatt 2014/40**

(51) Int Cl.:
*H02P 6/16* *(2006.01)*     *H03M 1/64* *(2006.01)*
*H03M 1/10* *(2006.01)*

(21) Anmeldenummer: **12152859.0**

(22) Anmeldetag: **27.01.2012**

(54) **Verfahren und Anordnung zur Bestimmung des dynamischen Zustands eines Elektromotors**

Method and assembly for determining the dynamic status of an electric motor

Procédé et agencement destiné à la détermination de l'état dynamique d'un moteur électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.11.2011 DE 102011055717**

(43) Veröffentlichungstag der Anmeldung:
**29.05.2013 Patentblatt 2013/22**

(73) Patentinhaber: **Dr. Fritz Faulhaber GmbH & Co. KG**
**71101 Schönaich (DE)**

(72) Erfinder:
• **Wagener, Andreas Dr.**
**71093 Weil im Schönbuch - Breitenstein (DE)**
• **Haag, Achim**
**70771 Leinfelden-Echterdingen (DE)**

(74) Vertreter: **Patentanwälte**
**Dr. Solf & Zapf**
**Schlossbleiche 20**
**42103 Wuppertal (DE)**

(56) Entgegenhaltungen:
DE-B3-102004 062 118     DE-B3-102006 017 024
JP-A- 2008 076 078       JP-A- 2011 141 207
US-A1- 2006 097 108      US-A1- 2007 029 955

**Beschreibung**

Die vorliegende Erfindung betrifft ein Verfahren und eine Anordnung zur Detektierung des dynamischen Zustands eines Elektromotors, insbesondere eines bürstenlosen, elektronisch kommutierten Gleichstrom-Servokleinmotors, wobei ein inkrementeller Positionsgeber eingesetzt wird, welcher für eine Anzahl von Inkrementen innerhalb einer Umdrehung des Rotors jeweils ein Ausgangssignal abgibt, das durch Superposition eines Basis-Grundsignals mit zeitlich zufällig und systematisch schwankenden Signalstörungen entsteht, wobei das Basis-Grundsignal aus mindestens zwei, jeweils entsprechend der Drehstellung des Rotors sich periodisch verändernden Teilsignalen besteht, welche in einer festen Winkelbeziehung zueinander stehen.

Für hochwertige Positionieraufgaben von Servomotoren in einem Winkelbereich unter einem Grad wird auch für baulich sehr kleine Antriebe eine Positionsauflösung von deutlich unter 0,1 ° pro Rotorumdrehung, entsprechend einer Inkrementzahl von deutlich über 3600 pro Umdrehung, für eine präzise und dynamische Regelung benötigt.

Für den Betrieb bürstenloser, elektronisch kommutierter Gleichstrommotoren (DC-Motoren) ist dabei einerseits die absolute Drehstellung des Rotors gegenüber dem Wicklungssystem für die Kommutierung nötig, andererseits ist - z. B. für vielfältige direkt, also ohne Getriebe, betriebene Positionieraufgaben - zusätzlich auch die Kenntnis der absoluten Drehstellung des Rotors innerhalb einer Motorumdrehung erforderlich.

Bekanntermaßen kann hoch auflösend eine inkrementelle Positionsbestimmung der Rotordrehlage z. B. durch einen an einen Motor angebauten optischen Positionsgeber erfolgen, wobei für die Anzahl der zeitlichen Inkremente innerhalb einer Umdrehung des Rotors ein Indexsignal bereitgestellt wird. Für den Betrieb von bürstenlosen DC-Motoren werden diese zur Gewinnung zusätzlicher Informationen für die elektronische Kommutierung (EC) auch mit digitalen Hallsensoren kombiniert. Über eine Referenzfahrt bis zum Auftreten des Indexsignals kann dabei nach jedem Einschalten eine hoch auflösende, innerhalb eines Winkels absolute Winkelinformation ermittelt werden. Nachteilig daran ist die übliche Baugröße der optischen Positionsgeber, die teilweise einen Durchmesser aufweisen, der ein Mehrfaches des Durchmessers eines für die Positionieraufgabe vorgesehenen Kleinmotors ist.

Entsprechend der DE 10 2008 010 964 kann alternativ auf ein Indexsignal des Gebers verzichtet werden, indem der Rotor zunächst in eine magnetisch ausgeprägte Referenzposition bewegt wird und die Rotorlage demgegenüber referenziert wird. Nachteilig daran ist die vergleichsweise ungenaue Referenzlage, da bedingt durch wechselnde Umgebungsbedingungen wie Temperatur oder Reibung der Rotor nur in einem ein Inkrement des hochauflösenden Gebers deutlich überschreitenden Winkelbereich des Inkrementalgebers referenziert werden kann.

Aus dem Fachartikel von R. Schwarz et al.: "Increasing Signal Accurancy of Automotive Wheel-Speed Sensors by On-line Learning" in Proceedings of the American Control Conference, Albuquerque, New Mexico, Juni 1997, Seiten 1131-1135 ist weiterhin ein Verfahren bekannt, bei dem für die Geberkompensation eines Inkrementalgebers ermittelten Korrekturfaktoren über einen Zeitraum hinweg, in dem aufgrund einer zu langsamen Bewegung des Sensors keine Geschwindigkeit ausgewertet werden kann, gespeichert werden. Nach wieder einsetzender Bewegung werden neue Korrekturfaktoren für das Geschwindigkeitssignal ermittelt und den vorher gespeicherten Korrekturfaktoren über eine Korrelation der beiden Signalfolgen wieder zugeordnet. Es handelt sich hierbei um ein Verfahren zur Korrektur einer aus einem Inkrementalgebersignal ermittelten Geschwindigkeit. Ziel des Verfahrens ist nicht, eine absolute Lage des Antriebssystems zu ermitteln.

Eine weitere vorteilhafte, aus dem Fertigungsprogramm der Anmelderin bekannte Möglichkeit zur hochauflösenden Detektierung einer Rotorposition besteht in der Integration eines auf der Auswertung wechselnder magnetischer Feldstärken aufbauenden magnetischen Sensors in einen Elektromotor. In einer Kombination des Sensors - insbesondere eines sogenannten AMR-Sensors (AMR = anisotroper magnetoresistiver Effekt) - mit einem axial magnetisierten, höherpolig mechanisch strukturierten, insbesondere gezahnten Geberrad kann dabei eine Auflösung von z. B. $100 * 10^3$ Inkrementen pro Rotorumdrehung - selbst für Motoren von nicht mehr als 8 mm Durchmesser - erreicht werden. Ein Sensorarray erzeugt dazu bevorzugt ein Basis-Grundsignal, das aus zwei, jeweils entsprechend der Drehstellung des Rotors sich periodisch verändernden Teilsignalen besteht, welche in einer festen Winkelbeziehung zueinander stehen. Insbesondere sind dies zwei um eine viertel Periode zueinander versetzte harmonische, dem Magnetfeld proportionale elektrische Teilsignale.

Die Anzahl der Signalperioden je Umdrehung entspricht dabei der Strukturierung des Geberrads. Die Geberauflösung ergibt sich dabei entsprechend der Anzahl der zeitlichen Inkremente innerhalb einer Umdrehung des Rotors, die als Produkt aus der Zähnezahl des Geberrades und einem Interpolationsfaktor innerhalb einer Signalperiode bestimmt werden kann. Verfahren, wie Interpolationsfaktoren und interpolierte Positionen innerhalb einer Periode eines harmonischen, insbesondere sinusförmigen Positionssignals festgelegt werden kann, sind dabei aus der Literatur, insbesondere aus der DE 198 15 964 B4 und der US 7 800 325 B2, bekannt. Nachteilig daran ist, dass wiederum lediglich eine hochauflösende inkrementelle Position ermittelt wird, wobei ohne zusätzliche Sensoren oder Verfahren aufgrund der Mehrdeutigkeit des harmonischen Ausgangssignals des Positionsgebers zwar in einem Quadranten einer Umdrehung, jedoch nicht innerhalb einer gesamten Umdrehung des Rotors eine eindeutige Referenzlage ermittelt werden kann.

In einem Ausgangssignal, welches ein Positionsgeber liefert, kann insbesondere ein hochfrequentes Basis-Grundsignal durch zeitlich zufällig und systematisch schwankende Signalstörungen überlagert sein. So können beispielsweise bei AMR-Gebern, bedingt durch Fertigungstoleranzen des Geberrads, die Charakteristika der Signale der harmonischen Schwingungen - wie Amplitude und Phasendifferenz - für jeden Zahn des Geberrads variieren. Die Signalschwankungen können dabei z. B. sowohl von einer ungleichmäßigen Magnetisierung, von Variationen der Zahnhöhen, als auch von einem nicht ideal planen, d. h. parallel zum Sensorarray ausgerichteten Einbau des Geberrads und einem dadurch innerhalb einer Umdrehung variierenden Abstand zwischen Geberrad und Sensorarray verursacht werden.

Damit durch Signalstörungen bei der Auswertung der Ausgangssignale die Genauigkeit einer resultierend bestimmten Rotor-Drehwinkel-Position nicht beeinträchtigt wird, können zur Kompensation unterschiedlicher Amplituden und Phasendifferenzen vor der Berechnung des Winkels Verfahren angewendet werden, wie sie beispielsweise aus der DE 10 2010 031 813 A1 oder der DE 198 15 964 B4 bekannt sind. Aus der EP 1 596 493 A1 ist des Weiteren ein Verfahren bekannt, wonach die Winkelfehler eines höherpoligen Gebersystems korrigiert werden, indem für eine Drehzahlermittlung Segmentlängen eines Gebersystems gegenüber einer mittleren Segmentlänge rechnerisch korrigiert werden. Für alle diese bekannten Verfahren ist es bezeichnend, dass - insbesondere durch die Berechnung von Korrekturwerten für die Messwerte des Geber-Ausgangssignals - Störungseinflüsse auf das Signal ausgeschaltet werden sollen. Zur genaueren Winkelbestimmung bei Resolvern schlagen die Dokumente JP 2011141207 und US 2007029955 den Einsatz von Bandpassfiltern und Korrelationsfunktionen vor.

Der Erfindung liegt die Aufgabe zugrunde, ein Verfahren, das die eingangs genannten Merkmale aufweist, sowie eine Anordnung zur Detektierung des dynamischen Zustands eines Elektromotors, insbesondere eines bürstenlosen, elektronisch kommutierten Gleichstrom-Servokleinmotors, zu schaffen, wobei insbesondere unter Benutzung eines hoch interpolierten, innerhalb einer Motorumdrehung mehrdeutigen Gebersystems eine innerhalb einer Umdrehung eindeutige, gegenüber der mechanischen Belastung des Motors und gegenüber Fertigungstoleranzen eines Positionsgebers robuste Bestimmung einer aktuellen Drehstellung sowie einer aktuellen Ausgangsdrehstellung relativ zu einer Referenz-Ausgangsdrehstellung erfolgen soll. Dabei soll diese, im Motorbetrieb für eine aktuelle Drehstellung des Rotors referenzierend einsetzbare aktuelle Ausgangsdrehstellung ausschließlich auf der Basis einer Auswertung der Signale des genannten, insbesondere mehrpoligen Gebersystems gewonnen werden, damit das erfindungsgemäße Verfahren auch an Motoren mit kleinem Durchmesser einsetzbar ist. Der konstruktive Aufwand soll dabei gering gehalten sein. Es soll also insbesondere kein zusätzlicher Sensor zur Bestimmung der für eine aktuell vorliegende Rotordrehstellung als referenzierend ansehbaren aktuellen Ausgangsdrehstellung verwendet werden.

Diese Aufgabe wird einerseits erfindungsgemäß durch ein Verfahren nach Anspruch 1 zur Detektierung des dynamischen Zustands eines Elektromotors, welcher einen Stator und einen Rotor aufweist, insbesondere eines bürstenlosen, elektronisch kommutierten Gleichstrom-Servokleinmotors, gelöst, dass innerhalb einer Umdrehung des Rotors eindeutige Bestimmungen von Drehstellungen des Rotors umfasst, und zwar die Bestimmung einer aktuellen Drehstellung des Rotors relativ zu einer aktuellen Ausgangsdrehstellung des Rotors sowie die Bestimmung dieser aktuellen Ausgangsdrehstellung relativ zu einer Referenz-Ausgangsdrehstellung des Rotors, wobei ein inkrementeller Positionsgeber eingesetzt wird, welcher für eine Anzahl von zeitlichen Inkrementen innerhalb einer Umdrehung des Rotors jeweils ein Ausgangssignal abgibt, das durch Superposition eines Basis-Grundsignals mit zeitlich zufällig und systematisch schwankenden Signalstörungen entsteht, wobei das Basis-Grundsignal aus mindestens zwei, jeweils entsprechend der Drehstellung des Rotors sich periodisch verändernden Teilsignalen besteht, welche in einer festen Winkelbeziehung zueinander stehen, wobei die Ermittlung der aktuellen Ausgangsdrehstellung ausschließlich aus dem Ausgangssignal des Positionsgebers erfolgt und durch einen Vergleich des zeitlichen Verlaufs des Anteils der systematisch schwankenden Signalstörungen von Messwerten einer aktuellen Signalfolge mit einem zeitlichen Verlauf des Anteils der systematisch schwankenden Signalstörungen von Messwerten einer ausgehend von der Referenz-Ausgangsdrehstellung gewonnenen Signalfolge des Ausgangssignals des Positionsgebers ermittelt wird.

Andererseits wird diese Aufgabe erfindungsgemäß durch eine Anordnung nach Anspruch 25 zur Detektierung des dynamischen Zustands eines Elektromotors, insbesondere eines bürstenlosen, elektronisch kommutierten Gleichstrom-Servokleinmotors, gelöst, die eine Motoransteuerung für den Elektromotor, einen inkrementellen Positionsgeber und eine Signalverarbeitungseinheit umfasst, wobei die Verarbeitungseinheit, welche zu einer innerhalb einer Umdrehung des Rotors des Elektromotors eindeutigen Bestimmung von Drehstellungen des Rotors dient, und zwar einer aktuellen Drehstellung relativ zu einer aktuellen Ausgangsdrehstellung sowie dieser aktuellen Ausgangsdrehstellung relativ zu einer Referenz-Ausgangsdrehstellung, eine Einheit zur Ermittlung einer für ein Signal des Positionsgebers charakteristischen Signalfolge, einen nichtflüchtigen Speicher für mindestens eine Referenzfolge des Signals und zwei Einheiten zur Bestimmung von jeweils einer ersten Bewertungskenngröße oder einer zweiten Bewertungskenngröße für die Signalfolgen sowie je eine, jeder Einheit zur Bestimmung der Bewertungskenngröße zugeordnete Einheit zur Ermittlung eines Winkelversatzes der aktuellen Ausgangsdrehstellung relativ zur Referenz-Ausgangsdrehstellung aus dem Vergleich einer aktuellen Signalfolge mit mindestens einer im Festwertspeicher hinterlegten Referenzfolge umfasst, wobei die Einheiten zur Ermittlung des Winkelversatzes derart ausgelegt sind, dass die Ermittlung des Winkelversatzes nach jeweils unterschiedlichen Verfahrensarten der Signalverarbeitung der aktuellen Signalfolge erfolgt.

Die Erfindung stützt sich dabei insbesondere auf die Ähnlichkeit eines charakteristischen zeitlichen Verlaufs des Anteils der systematisch schwankenden Signalstörungen eines aktuellen Ausgangssignals des Positionsgebers mit einem charakteristischen zeitlichen Verlauf des Anteils der systematisch schwankenden Signalstörungen eines Ausgangssignals für die Referenz-Ausgangsdrehstellung. Anstelle dabei den Versuch zu unternehmen, die vorhandenen Störungen durch verschiedenartige Korrekturverfahren zu kompensieren, werden die Störungen dazu benutzt, um die aktuelle Ausgangsdrehstellung des Rotors in ihrer Relation zu einer Referenz-Ausgangsdrehstellung als Winkelversatz zu bestimmen.

Um den Vergleich des zeitlichen Verlaufs des Anteils der systematisch schwankenden Signalstörungen vornehmen zu können, ist es einerseits möglich, direkt von den Messwerten der aktuell bestimmten Signalfolge und der für die Referenz-Ausgangsdrehstellung gewonnenen Signalfolge des Ausgangssignals des Positionsgebers auszugehen oder auch vorzusehen, den zeitlichen Verlauf nur der Signalstörungen des Ausgangssignals vor einer weiteren Signalverarbeitung jeweils durch eine Mittelwertbildung der Messwerte aus den Signalfolgen des Ausgangssignals und Subtraktion des Mittelwertes von den jeweiligen Messwerten der Signalfolgen aus den Signalfolgen zu extrahieren und der weiteren Auswertung zugrunde zu legen.

Die Messwerte der ausgehend von der Referenz-Ausgangsdrehstellung gewonnenen Signalfolge und gegebenenfalls der isolierten Werte der Signalstörungen des Ausgangssignals des Positionsgebers können bevorzugt nach einer initialen, z. B. bei einer Endprüfung nach der Fertigung des Elektromotors festgelegten, Ausrichtung des Rotors in einer Vorzugsdrehstellung oder durch Kopplung mit einem externen Referenzgeber ermittelt und in einem nichtflüchtigen Speicher niedergelegt werden.

Vor jeder Signalverarbeitung zur Vornahme des erfindungsgemäß durchzuführenden Vergleichs können die Messwertfolgen notwendigenfalls kompatibel zueinander gestaltet werden, indem eine während des Betriebs, z. B. während einer Referenzfahrt gewonnene Folge von charakteristischen Signalwerten gegenüber einer im Speicher des Antriebs abgelegten Referenzfolge abgeglichen wird. Zum Abgleich der Messwertfolgen kann insbesondere die Anzahl der Messwerte der aktuellen Signalfolge des Ausgangssignals des Positionsgebers mit der Anzahl der Messwerte der ausgehend von der Referenz-Ausgangsdrehstellung gewonnenen Signalfolge des Ausgangssignals des Positionsgebers verglichen werden. Wenn die Anzahl der Messwerte der aktuellen Signalfolge größer ist als die Anzahl der Messwerte der ausgehend von der Referenz-Ausgangsdrehstellung gewonnenen Signalfolge, kann durch einfache oder mehrfache vollständige und/oder teilweise repetitive Anfügung der Messwerte der Signalfolge aus der ausgehend von der Referenz-Ausgangsdrehstellung gewonnenen Signalfolge eine abgeglichene Signalfolge mit der gleichen Anzahl der Messwerte gebildet werden, wie die Anzahl der Messwerte der aktuellen Signalfolge. Die abgeglichene Signalfolge kann dann - wie nachstehend für die ursprünglichen Messwerte beschrieben - anstelle der ausgehend von der Referenz-Ausgangsdrehstellung gewonnenen Signalfolge eingesetzt werden.

Um die Natur der Störungseinflüsse in den Ausgangssignalen des Gebers zu erfassen, kann mit Vorteil vorgesehen sein, dass aus den Signalfolgen des zeitlichen Verlaufs der Signalstörungen des Ausgangssignals, das ausgehend von der Referenz-Ausgangsdrehstellung ermittelt wurde, und/oder des Ausgangssignals in der aktuellen Drehstellung des Rotors jeweils eine Bewertungskenngröße für die Charakteristik des zeitlichen Störungsverlaufs ermittelt wird. Entsprechend einem Wert dieser Bewertungskenngrößen kann dann eine Auswahl einer ersten oder einer zweiten Verfahrensart, nach welcher jeweils der Vergleich des zeitlichen Verlaufs des Anteils der systematisch schwankenden Signalstörungen des aktuellen Ausgangssignals mit dem zeitlichen Verlauf des Anteils der systematisch schwankenden Signalstörungen des Ausgangssignals des Positionsgebers in der Referenz-Ausgangsdrehstellung vorgenommen wird, erfolgen.

Es kann auch der Fall eintreten, dass die für die Bewertungskenngrößen bestimmten Zahlenwerte anzeigen, dass für die zur Verfügung stehenden Signalfolgen eine Verarbeitbarkeit, die hinreichende Genauigkeit liefert, nicht gegeben ist. Dies ist z. B. dann der Fall, wenn sich einerseits der zeitliche Verlauf der Signalstörungen des aktuellen Ausgangssignals des Positionsgebers nicht signifikant von einem Basis-Grundsignal mit zeitlich ausschließlich zufällig schwankenden Signalstörungen unterscheidet, was durch eine erste Bewertungskenngröße signalisiert werden kann, und wenn andererseits auch gleichzeitig der zeitliche Verlauf der Signalstörungen des aktuellen Ausgangssignals des Positionsgebers einen Grundschwingungsanteil für die systematisch schwankenden Signalstörungen aufweist, der sich nicht signifikant von allen übrigen Schwingungsanteilen der Signalstörungen unterscheidet, was durch eine zweite Bewertungskenngröße angezeigt werden kann. In diesem Fall kann eine Veränderung der Einsatzbedingungen des inkrementellen Positionsgebers und/oder des inkrementellen Positionsgebers selbst erfolgen, so dass derart zumindest für die zweite Bewertungskenngröße, indem z. B. mechanische Eigenschaften eines der Messwertgewinnung dienenden Geberrads in einer AMR-Messanordnung optimiert werden, ein für die Ermittlung der aktuellen Ausgangsdrehstellung hinreichend signifikanter zeitlicher Messwertverlauf innerhalb des aktuellen Ausgangssignals des Positionsgebers erzwungen wird.

Wenn der zeitliche Verlauf der Signalstörungen des aktuellen Ausgangssignals des Positionsgebers sich signifikant von einem Basis-Grundsignals mit zeitlich ausschließlich zufällig schwankenden Signalstörungen unterscheidet, kann eine erste Verfahrensart ausgewählt werden, nach welcher jeweils der Vergleich des zeitlichen Verlaufs des Anteils der systematisch schwankenden Signalstörungen des aktuellen Ausgangssignals mit dem zeitlichen Verlauf des Anteils der systematisch schwankenden Signalstörungen des Ausgangssignals des Positionsgebers in der Referenz-Ausgangsdrehstellung vorgenommen wird. Gemäß dieser ersten Verfahrensart kann vorgesehen sein, dass aus den Messwerten der aktuellen Signalfolge und aus den Messwerten der ausgehend von der Referenz-Ausgangsdrehstellung gewonnenen Signalfolge eine Kreuzkorrelationsfunktion gebildet wird. Die aktuelle Ausgangsdrehstellung kann daraus in ihrer Relation zur Referenz-Ausgangsdrehstellung als ein Winkelversatz bestimmt werden, welches sich aus dem Abszissenwert des Maximums der Kreuzkorrelationsfunktion ergibt.

Ist die vorstehend genannte Bedingung nicht erfüllt, zeigt aber die zweite Bewertungskenngröße eine für eine genaue Bestimmung der aktuellen Ausgangsdrehstellung ausreichende Messwertsignifikanz im Hinblick auf die zweite Verfahrensart an, nach welcher jeweils der Vergleich des zeitlichen Verlaufs des Anteils der systematisch schwankenden Signalstörungen des aktuellen Ausgangssignals mit dem zeitlichen Verlauf des Anteils der systematisch schwankenden Signalstörungen des Ausgangssignals des Positionsgebers in der Referenz-Ausgangsdrehstellung vorgenommen werden kann, so ist es möglich, diese zweite Verfahrensart signaltechnisch umzusetzen. Dieser Verfahrensart entsprechend kann aus den Messwerten der Signalfolgen, insbesondere nach einer Fouriertransformation der Messwerte, die aktuelle Ausgangsdrehstellung in ihrer Relation zu einer Referenz-Ausgangsdrehstellung als Winkelversatz bestimmt werden, welches sich aus einer Differenz der Phasenlagen der Grundschwingungsanteile der Signalfolgen ergibt.

Das erfindungsgemäße Verfahren kann vorteilhafterweise mit inkrementellen Positionsgebern praktiziert werden, die induktive, magnetische, wie Hall-, AMR- oder GMR-Sensoren, oder optische Sensoren enthalten. Die Anzahl der Inkremente kann dabei in einem Bereich von 3000 bis 100000 bezogen auf eine vollständige Umdrehung des Rotors liegen, so dass eine vorteilhaft hochgenaue Auflösung erreicht wird.

Weitere vorteilhafte Ausgestaltungsmerkmale der Erfindung sind in den Unteransprüchen sowie der folgenden Beschreibung enthalten.

Anhand eines durch die beiliegende Zeichnung veranschaulichten erfindungsgemäßen Ausführungsbeispiels wird die Erfindung näher erläutert.

Dabei zeigen:

Fig. 1   in perspektivischer Darstellung, einen Gleichstrom-Kleinmotor, dessen dynamischer Zustand mittels des erfindungsgemäßen Verfahrens detektiert werden kann,

Fig. 2   den exemplarischen Verlauf eines Ausgangssignals eines in dem erfindungsgemäßen Verfahren eingesetzten inkrementellen Positionsgebers,

Fig. 3   einen vereinfachten Signalflussplan eines erfindungsgemäßen Verfahrens,

Fig. 4   einen ersten möglichen normierten Verlauf einer Gebercharakteristik eines in dem erfindungsgemäßen Verfahren einsetzbaren inkrementellen Positionsgebers,

Fig. 5   einen weiteren möglichen normierten Verlauf einer derartigen Gebercharakteristik,

Fig. 6   ein Schema einer aus einer Motoransteuerung für einen Kleinmotor und einer Signalverarbeitungseinheit gebildeten Anordnung zur Durchführung des erfindungsgemäßen Verfahrens,

Fig. 7   eine diagrammatische Darstellung eines ersten exemplarischen zeitlichen Verlaufs von Messwerten in einer Signalfolge eines Ausgangssignals eines in dem erfindungsgemäßen Verfahren eingesetzten inkrementellen Positionsgebers bei verschiedenen Temperaturen,

Fig. 8   eine diagrammatische Darstellung eines zweiten exemplarischen zeitlichen Verlaufs von Messwerten in einer Signalfolge eines Ausgangssignals eines in dem erfindungsgemäßen Verfahren eingesetzten inkrementellen Positionsgebers bei verschiedenen Temperaturen,

Fig. 9   eine diagrammatische Darstellung einer aus dem ersten exemplarischen Verlauf von Messwerten gemäß Fig. 7 gewonnenen Autokorrelationsfunktion bei verschiedenen Temperaturen,

Fig. 10   eine diagrammatische Darstellung einer aus dem zweiten exemplarischen Verlauf von Messwerten gemäß Fig. 8 gewonnenen Autokorrelationsfunktion bei verschiedenen Temperaturen,

Fig. 11   eine diagrammatische Darstellung einer Kreuzkorrelationsfunktion, berechnet aus einer aktuellen Signalfolge und den Messwerten gemäß dem ersten exemplarischen Verlauf der Messwerte nach Fig. 7 als Referenzfolge,

Fig. 12    eine diagrammatische Darstellung einer Kreuzkorrelationsfunktion, berechnet aus einer aktuellen Signalfolge und den Messwerten gemäß dem zweiten exemplarischen Verlauf der Messwerte nach Fig. 8 als Referenzfolge,

Fig. 13    ein Diagramm von aus dem ersten exemplarischen Verlauf von Messwerten gemäß Fig. 7 gewonnenen fouriertransformierten Grundschwingungsanteilen bei verschiedenen Temperaturen,

Fig. 14    ein Diagramm von aus dem zweiten exemplarischen Verlauf von Messwerten gemäß Fig. 8 gewonnenen fouriertransformierten Grundschwingungsanteilen bei verschiedenen Temperaturen,

Fig. 15    ein Diagramm wie in Fig. 14, jedoch nur bei einer einzigen Temperatur, wobei eingezeichnet ist, dass daraus eine Ermittlung eines Winkelversatzes gegenüber der Referenzlage erfolgen kann,

Fig. 16    eine diagrammatische Felddarstellung der für verschiedene inkrementelle Positionsgeber charakteristischen Werte einer ersten und einer zweiten Bewertungskenngröße für den zeitlichen Verlauf von Messwerten in einer jeweils mit dem Inkrementalgeber bestimmten Signalfolge.

Zu der anschließenden Beschreibung wird ausdrücklich betont, dass die Erfindung nicht auf die Ausführungsbeispiele und dabei auch nicht auf alle oder mehrere Merkmale von beschriebenen Merkmalskombinationen beschränkt ist, vielmehr kann jedes einzelne Teilmerkmal des/jedes Ausführungsbeispiels auch losgelöst von allen anderen im Zusammenhang damit beschriebenen Teilmerkmalen für sich und auch in Kombination mit beliebigen Merkmalen eines anderen Ausführungsbeispiels eine erfinderische Bedeutung haben.

In den Figuren der Zeichnung sind gleiche Teile stets auch mit den gleichen Bezugszeichen versehen, so dass sie in der Regel auch jeweils nur einmal beschrieben werden.

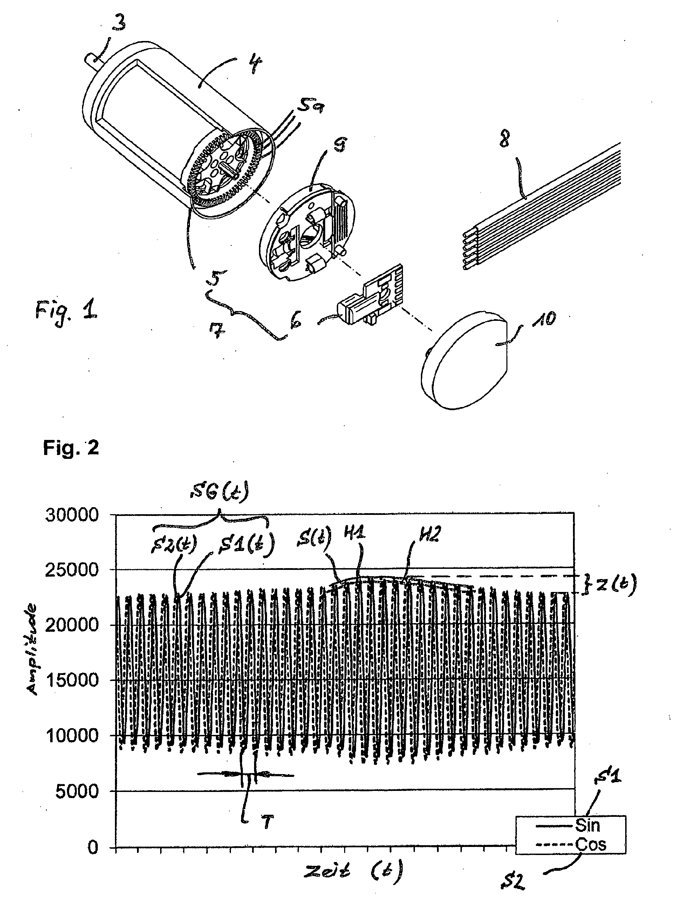

Bei dem in Fig. 1 perspektivisch und teilweise in Explosionsdarstellung gezeigten Elektromotor 1 handelt es sich um einen DC-, insbesondere EC-Kleinmotor, dessen dynamischer Zustand mittels des erfindungsgemäßen Verfahrens detektiert werden kann.

In der Zeichnung sind die Wicklungen der Spule sowie die Welle 3 des Rotors 2 des Elektromotors zu sehen, die in einem Gehäuse 4 gelagert sind. In der dargestellten bevorzugten Ausführung sitzt die Spule drehfest auf der Welle 3. Der Rotor 2 ist nicht auf einen Eisenkern gewickelt, sondern besteht aus der freitragenden, insbesondere in Schrägwicklung gewickelten Spule und umschließt einen nicht sichtbaren Statormagneten. Das Gehäuse 4 bildet dabei den Eisenrückschluss.

Am Rotor 2, insbesondere drehfest auf der Welle 3, ist ein magnetischer Zahnring 5 mit einer Anzahl $n_z$ von Zähnen 5a befestigt, der zusammen mit einem speziellen Hybridschaltkreis einer Sensorelektronik 6 einen inkrementellen Positionsgeber 7 bildet. Die Sensorelektronik kann über einen Kabelanschluss 8, insbesondere - wie dargestellt - über ein Flachbandkabel, kontaktiert werden und ist im Montagezustand koaxial zu dem magnetischen Zahnring 5 zwischen einem inneren Deckel 9 und einem äußeren Deckel 10 angeordnet. Ein in die Sensorelektronik 6 integrierter Sensor wandelt Magnetfelddifferenzen zwischen Zahnkopf und Zahnfuß in elektrische Signale um.

Ein Sensorarray der Sensorelektronik 6 erzeugt dabei ein Basis-Grundsignal SG, wie es exemplarisch in Fig. 2 dargestellt ist. Dieses Basis-Grundsignal SG besteht dabei aus mindestens zwei, jeweils entsprechend der Drehstellung des Rotors 2 sich periodisch verändernden Teilsignalen S1, S2, welche in einer festen Winkelbeziehung zueinander stehen. Die Signale können - wie in Fig. 2 gezeigt - als Funktionen der Zeit S(t), S1(t), S2(t) oder als Funktionen des Drehwinkels S(φ), S1(φ), S2(φ) aufgefasst werden.

Bevorzugt kann es sich bei den Teilsignalen S1, S2, wie dies Fig. 2 zu entnehmen ist, um zwei um eine viertel Periode (90 °) zueinander versetzte, sich periodisch verändernde, insbesondere harmonische, dem Magnetfeld des Geberrades 5 proportionale elektrische Signale S1, S2 gleicher Frequenz handeln. Das erste Teilsignal S1 in Fig. 2 ist dabei ein Sinussignal, das zweite Teilsignal S2 ein Kosinussignal.

Derartige Signale S1, S2 können beispielsweise auch mittels eines optischen Encoders gewonnen werden. So kann in einem solchen Encoder anstelle der Magnetscheibe 5 eine trägheitsarme, mehrteilige Kodierscheibe angeordnet sein, die im Durchlichtverfahren von beispielsweise infrarotem Licht durchstrahlt wird. Die Sensorelektronik 6 muss dann komplementär einen entsprechenden optischen Sensor enthalten. In einem so gebildeten optischen inkrementalen Positionsgeber 7 kann das ausgestrahlte Licht reflektiert bzw. absorbiert werden und erzeugt auf diese Weise die phasenverschobenen Impulse.

Die Anzahl $n_z$ der Signalperioden T je Umdrehung - in Fig. 2 sind die Verhältnisse für eine Umdrehung des Rotors 3 dargestellt - ergibt sich aus der Strukturierung des Geberrads 5, beispielsweise daraus, wieviel Zähne 5a oder - allgemein gesprochen - Pole das Geberrad 5 aufweist. Eine in Winkeleinheiten ausgedrückte Geberauflösung oder ein Inkrement Δφ ergibt sich dabei für den dargestellten magnetischen Positionsgeber 7 durch Division des einer Umdrehung des Rotors 2 entsprechenden Winkels von 360 ° durch das Produkt aus der Anzahl $n_z$ der Signalperioden des inkrementellen Gebersignals pro Motorumdrehung und einem Interpolationsfaktor $n_i$ innerhalb einer Signalperiode T. Die Anzahl $n_z$ der Signalperioden wird dabei z. B. durch die Zähnezahl eines Gebers bestimmt, welche im dargestellten Fall 36 beträgt. Beispielsweise werden bei einem Interpolationsfaktor von $n_i$ = 1 bei Auswertung der beiden um 90° versetzten Teilsignale S1, S2 vier Positionsinkremente $\Delta\varphi$ pro Zahn 5a ausgegeben.

Der Winkel innerhalb einer Umdrehung ergibt sich dann nach Gleichung (1) zu:

$$\varphi_{ges}(i) = n_{z,offs} \cdot \frac{2\pi}{n_z} + \varphi(i) = n_{z,offs} \cdot \frac{2\pi}{n_z} + \arctan\left(\frac{S1(i)}{S2(i)}\right) \tag{1}$$

Dabei sind:

$\varphi_{ges}(i)$     - ein aktueller Winkel innerhalb einer Umdrehung,

$n_{z,offs}$     - ein aktueller Winkelversatz gegenüber der Nulllage (aktuelle Ausgangsdrehstellung A gegenüber der Referenz-Ausgangsdrehstellung O) einer Umdrehung in Zahnteilungen,

$n_z$     - die Anzahl der Signalperioden des inkrementellen Gebersignals pro Motorumdrehung,

$\varphi(i)$     - ein aktueller Winkel innerhalb der Zahnteilung aus der Auswertung der beiden um 90° verschobenen Signale,

$i$     eine dimensionslose diskretisierte Abtastgröße mit i = $t_i$/T, wobei $t_i$ die aktuelle Zeit und T die Dauer einer Signalperiode ist.

Wie bereits erwähnt, können - z. B. bedingt durch Fertigungstoleranzen oder auch durch die Einbauverhältnisse des Gebers - die Charakteristika der Teilsignale S1, S2, wie Amplitude und Phasendifferenz, für jeden Zahn 5a des Geberrads 5 variieren. Die Amplitudenschwankungen der Teilsignale S1, S2 sind dabei in Fig. 2 insbesondere durch die Hüllkurven H1, H2 veranschaulicht. Die Schwankungen der Signale S bzw. S1, S2 können dabei aus einer ungleichmäßigen Magnetisierung, aus Variationen der Höhe der Zähne 5a oder aus einem nicht planparallelen Einbau des Geberrads 5 in Relation zur Sensorelektronik 6 resultieren. Dies führt dazu, dass in einem Ausgangssignal S, das aus dem Basis-Grundsignal SG letztendlich entsteht, Letzteres von zeitlich zufällig und von systematisch schwankenden Signalstörungen Z (t) überlagert ist. Anders gesagt: das Basis-Grundsignal ist frequenz- oder insbesondere, wie der Verlauf der Hüllkurven H1, H2 in Fig. 2 zeigt, amplitudenmoduliert.

Die Erfindung basiert darauf, dass die durch die Störungen Z bedingten schwankenden Charakteristika, wie insbesondere die Amplitude des Ausgangssignals S pro Zahn 5a des Geberrads 5, ausgewertet werden. Der jeweilige Mittelwert aller zur Auswertung heranziehbaren Signalfolgen kann daher eliminiert werden. Das bedeutet, dass die Signalstörungen Z des Ausgangssignals S vor einer weiteren Signalverarbeitung aus dem Signal S extrahiert werden kann, indem eine Mittelwertbildung für das Ausgangssignal S vorgenommen wird und der Mittelwert (dieser entspricht der Amplitude von SG in Fig. 2) von den Einzelwerten des Ausgangssignals S subtrahiert wird.

In einer anderen Variante kann auch eine Folge von Maxima des Signals S innerhalb einer Umdrehung oder gleichwertig eine Folge von Minima innerhalb einer Umdrehung ausgewertet werden. Diese Größen sind ebenfalls repräsentativ für die dem Basis-Grundsignal SG aufgeprägten Störungen Z. Ebenso können alternativ auch weitere einfach auszuwertende Signalcharakteristika, wie z.B. die Amplituden der Schnittpunkte der beiden um 90 ° verschobenen Teilsignale S1, S2 für die Auswertung herangezogen werden.

Erfindungsgemäß erfolgt die Ermittlung einer für einen momentanen Zeitpunkt bzw. für einen momentanen Zeitabschnitt der Detektierung des dynamischen Zustands des Elektromotors 1 charakteristischen aktuellen Ausgangsdrehstellung A ausschließlich aus dem Ausgangssignal S des Positionsgebers 7, und zwar durch einen Vergleich des zeitlichen Verlaufs des Anteils der systematisch schwankenden Signalstörungen Z(t) eines aktuellen Ausgangssignals S(t) mit einem zeitlichen Verlauf des Anteils der systematisch schwankenden Signalstörungen Z(t) eines ausgehend von einer Referenz-Ausgangsdrehstellung O gewonnenen Ausgangssignals S(t) des Positionsgebers 7.

Für ein Geberrad 5 mit $n_z$ Zähnen 5a, oder allgemein einen Geber mit $n_z$ Polen, können dabei für die Signale S, S1, S2 Signalfolgen gewonnen werden, die vorzugsweise aus einer Anzahl $n_z$ von Messwerten bestehen.

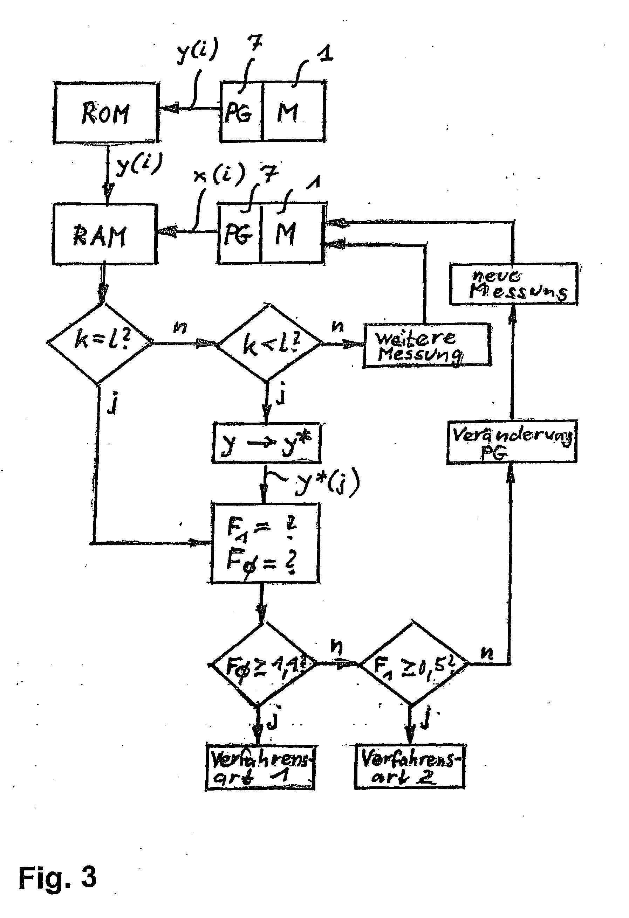

Die Messwerte der ausgehend von der Referenz-Ausgangsdrehstellung O gewonnenen Messwertfolge für das Ausgangssignal S und gegebenenfalls für dessen Signalstörungen Z können bevorzugt nach einer initialen, z. B. bei einer Endprüfung nach der Fertigung des Elektromotors 1 festgelegten Ausrichtung des Rotors 2 in einer Vorzugsdrehstellung oder durch Kopplung mit einem externen Referenzgeber ermittelt und vorzugsweise in einem nichtflüchtigen Speicher ROM niedergelegt werden, wie dies der Signalflussplan in Fig. 3 zeigt. Diese initiale für die Referenz-Ausgangsdrehstellung O aufgenommene Messwertfolge wird im Weiteren mit y(i) bezeichnet.

Eine aktuelle Signalfolge von Messwerten wird stattdessen mit x(i) bezeichnet und kann vorzugsweise in einem flüchtigen Speicher RAM niedergelegt werden, in den die Messwerte der früheren Messwertfolge y(i) zur Signalverarbeitung überführt werden können.

Für die weitere Signalverarbeitung sollten die Signalfolgen $x(i) = \{x_1, x_2 \ldots x_i \ldots x_I\}$ und $y(i) = \{y_1, y_2 \ldots y_i \ldots y_k\}$ bevorzugt die gleiche Länge, d. h. die gleiche Anzahl von Messwerten aufweisen. Wie Fig. 3 zeigt, kann daher zunächst überprüft werden, ob die Anzahl I der Messwerte der aktuellen Signalfolge x(i) mit der Anzahl k der Messwerte der ausgehend von der Referenz-Ausgangsdrehstellung O gewonnenen Signalfolge y(i) übereinstimmt. Ist dies der Fall, kann mit der eigentlichen Signalverarbeitung begonnen werden.

Wenn die Anzahl I der Messwerte der aktuellen Signalfolge x(i) größer ist als die Anzahl k der Messwerte der ausgehend von der Referenz-Ausgangsdrehstellung O gewonnenen Signalfolge y(i), kann durch einfache oder mehrfache vollständige und/oder teilweise repetitive Anfügung der Messwerte y(i) der Signalfolge der Referenz-Ausgangsdrehstellung O an deren ursprüngliche Messwerte eine abgeglichene Signalfolge $y^*(j) = \{\{y_{1,1}, y_{2,2} \ldots y_{i,j} \ldots y_{k,k}\}, \{y_{1,k+1}, y_{2,k+2} \ldots y_{i,k+i} \ldots y_{k,k+k}\}, \{y_{1,2k+1}, y_{2,2k+2} \ldots y_{i,2k+i} \ldots y_{i,2k+k}\}, \ldots\}$ mit der gleichen Anzahl n der Messwerte gebildet werden wie die Anzahl I der Messwerte der aktuellen Signalfolge x(i). Diese abgeglichene Signalfolge $y^*(j)$ kann dann anstelle der Signalfolge y(i) in analoger Weise der weiteren Signalverarbeitung zugeführt werden. Nachfolgend wird daher der Einfachheit bzw. Übersichtlichkeit halber nur noch die Signalfolge y(i) genannt.

Sollte stattdessen die Anzahl I der Messwerte der aktuellen Signalfolge x(i) kleiner sein als die Anzahl k der Messwerte der ausgehend von der Referenz-Ausgangsdrehstellung O gewonnenen Signalfolge y(i), kann eine weitere Messwertaufnahme erfolgen.

So kann gewährleistet werden, dass beide Messwertfolgen x(i) und y(i) bzw. $y^*(j)$ die gleiche Länge aufweisen, wobei gilt, dass I gleich k gleich vorzugsweise $n_z$ ist.

Um zunächst zu überprüfen, ob die vorhandenen Messwertfolgen x(i), y(i) geeignet sind, um daraus durch einen Vergleich des zeitlichen Verlaufs des Anteils der systematisch schwankenden Signalstörungen die Ermittlung der aktuellen Ausgangsdrehstellung A vorzunehmen, und um zu entscheiden, welche Verfahrensart dafür am besten geeignet ist, können aus den Signalfolgen Bewertungskenngrößen, insbesondere eine erste Bewertungskenngröße $F_\Phi$ und eine zweite Bewertungskenngröße $F_1$, gebildet werden.

Die erste Bewertungskenngröße $F_\phi$ gibt Auskunft darüber, ob die für eine unter allen Betriebszuständen sichere Detektion des Winkelversatzes $n_{z,offs}$ notwendige Bedingung erfüllt ist, dass ein über eine Umdrehung hinreichend charakteristischer Verlauf der zur Auswertung herangezogenen Signalgröße vorliegt.

Die erste Bewertungskenngröße $F_\Phi$ kann dabei insbesondere als Quotient des globalen Maximalwertes einer aus der Signalfolge y(i) des zeitlichen Verlaufs des Ausgangssignals des Positionsgebers ausgehend von der Referenz-Ausgangsdrehstellung O gewonnenen Autokorrelationsfunktion und des Maximalwertes einer aus der Signalfolge des zeitlichen Verlaufs des Ausgangssignals gewonnenen Autokorrelationsfunktion gebildet werden, wie dies die nachfolgende Gleichung (2) ausdrückt:

$$F_\phi = \frac{\phi_{y,y}(0)}{\max\limits_{\tau \neq 0}\left(\phi_{y,y}(\tau)\right)} \qquad (2)$$

Dabei gilt für die asymmetrisch definierte Autokorrelationsfunktion:

$$\phi_{y,y}(\tau) = \sum_{i=1}^{n_z} y(i) \cdot y(i+\tau) \qquad (3)$$

$F_\phi$ ist darin das Verhältnis des globalen Maximums $M_0 = \Phi_{y,y}(0)$ einer nach Gleichung (2) berechneten Autokorrelation der Referenzfolge y(i) mit dem nächst größten lokalen Maximum $M_1 = \Phi_{y,y}(T)$.

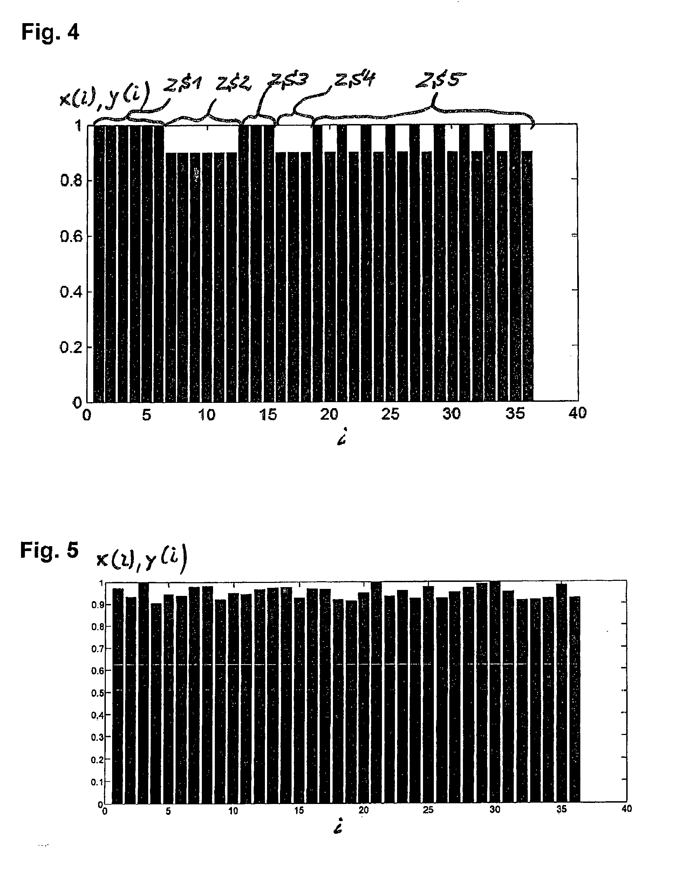

Ein maximaler Abstand zwischen den Maxima $M_1$, $M_2$ liegt beispielsweise dann vor, wenn eine vom Inkrementalgeber 7 gelieferte Signalcharakteristik, die z. B. durch die Gestaltung der Zähne 5a des Geberrades 5 erzielt werden kann, eine derartige ist, wie durch in Fig. 4 oder Fig. 5 veranschaulicht wird.

Fig. 4 zeigt als Blockdiagramm einen ersten möglichen charakteristischen Verlauf einer Gebercharakteristik, mittels derer - unabhängig von einem zusätzlichen, der letztendlich gemessenen Messwertfolge y(i) überlagerten Störungsverlauf, welcher durch Schwankungen bei der Fertigung des Geberrades 5 hervorgerufen werden kann - eine Bestimmung des aktuellen Winkelversatzes $n_{z,offs}$ gegenüber der Nulllage O zuverlässig möglich ist. Hierbei besteht eine exemplarisch konstruktiv für den Geber 7 vorgesehene Normierung bzw. Codierung darin, dass es binär nur zwei Zahnhöhen gibt: "große Zähne" 5a und "kleine Zähne" 5a. Über den Umfang des Geberrades 5 alternieren die "großen Zähne" 5a und die "kleinen Zähne" 5a nach einem vorgegebenen, bei der Signalerfassung eindeutig wiedererkennbaren Muster von Zahnsegmenten ZS1, ZS2, ZS3, ZS4, ZS5. Das erste Segment ZS1 besteht dabei aus sechs großen Zähnen 5a; das zweite Segment ZS2 besteht aus sechs kleinen Zähnen 5a; das dritte Segment ZS3 besteht aus drei großen Zähnen 5a; das vierte Segment ZS1 besteht aus drei kleinen Zähnen 5a; das fünfte Segment besteht aus 18 wechselweise großen und kleinen Zähnen 5a.

Fig. 5 zeigt einen weiteren möglichen normierten Verlauf einer Gebercharakteristik, mittels derer ebenfalls - unabhängig vom zusätzlich auftretenden, fertigungsbedingt schwankenden Verlauf der Signalstörungen Z(t) - eine Bestimmung des Winkelversatzes $n_{z,offs}$ zuverlässig möglich ist. Bei den hier als Balken dargestellten "Messwerten y(i)" ist ein gleichförmiges (konstantes) Grundsignal mit einem aus einer Pseudozufallsfolge errechneten zusätzlichen Signalanteil überlagert. Dem Mittelwert SG der Folge y(i) kann - signaltechnisch formuliert - vorteilhafterweise ein sogenanntes "weiße Rauschen" überlagert sein. Diese "Messwerte y(i)" - die in Anführungszeichen gesetzt sind, weil es sich dabei im erfindungsgemäßen Verfahren um Messwert-Zielgrößen handelt - werden bei der Herstellung des Geberrades 5 den Höhen der Zähne 5a aufgeprägt, wobei dem Mittelwert SG der Folge y(i) eine mittlere Zahnhöhe entspricht.

Wenn der zeitliche Verlauf der Signalstörungen Z(t) des aktuellen Ausgangssignals S(t) sich signifikant von einem Basis-Grundsignal SG mit überlagerten zeitlich ausschließlich zufällig schwankenden Signalstörungen Z unterscheidet, insbesondere, wenn die erste Bewertungskenngröße $F_\phi$ einen Wert von $\geq 1{,}1$ annimmt, kann eine erste Verfahrensart ausgewählt werden, nach welcher jeweils der Vergleich des zeitlichen Verlaufs des Anteils der systematisch schwankenden Signalstörungen Z(t) des aktuellen Ausgangssignals - repräsentiert durch die Signalfolge x(i) - mit dem zeitlichen Verlauf des Anteils der systematisch schwankenden Signalstörungen des Ausgangssignals des Positionsgebers 7 in der Referenz-Ausgangsdrehstellung O - repräsentiert durch die Signalfolge y(i) - vorgenommen wird. Nach der ersten Verfahrensart werden die zufällig je Zahn 5a schwankenden Werte der charakteristischen Signale ausgewertet, wie dies noch nachfolgend im Detail beschrieben wird.

Wenn die erste Verfahrensart nicht anwendbar ist, muss überprüft werden, ob die zweite Verfahrensart angewendet werden kann. Diese erfordert, dass aus der Signalfolge x(t) des zeitlichen Verlaufs der Signalstörungen des Ausgangssignals des Positionsgebers in der aktuellen Drehstellung und aus der Signalfolge y(t) des zeitlichen Verlaufs der Signalstörungen Z(t) des Ausgangssignals S(t) des Positionsgebers 7 ausgehend von der Referenz-Ausgangsdrehstellung O , ein Grundschwingungsanteil bestimmt wird, der für den zeitlichen Verlauf der systematisch schwankenden Signalstörungen Z(t) charakteristisch ist. Hierzu können insbesondere Fouriertransformationen der Signalfolgen x(i), y(i) zu

$$X(i) = \text{FFT}(x(i)) \text{ und } Y(i) = \text{FFT}(y(i)) \tag{4}$$

vorgenommen werden.

Der Operand FFT beschreibt dabei die Vornahme eine schnellen Fourier-Transformation (englisch "fast Fourier transform"), die ein Algorithmus zur effizienten Berechnung der Werte einer diskreten Fourier-Transformation (DFT) ist. Bei solchen an sich bekannten Algorithmen werden im Gegensatz zu einer direkten Berechnung zuvor berechnete Zwischenergebnisse benutzt, wodurch arithmetische Rechenoperationen eingespart werden können.

Bedingung für eine sichere Detektion des Winkelversatzes $n_{z,offs}$ nach der zweiten Verfahrensart ist ein ausreichend hoher Anteil X(1) der Grundschwingung bezogen auf die quadratische Summe der gesamten Schwingungsanteile X(i). Als Kriterium dafür kann daher die zweite Bewertungskenngröße $F_1$ herangezogen werden, wobei zu deren Berechnung der zeitliche Verlauf der Signalstörungen Z(t) des Ausgangssignals S des Positionsgebers 7 in der aktuellen Drehstellung herangezogen und entsprechend der nachfolgenden Gleichung (5) ein Vergleich des für die systematisch schwankenden Signalstörungen charakteristischen Grundschwingungsanteils X(1) mit der Größe aller Schwingungsanteile X(i) vorgenommen wird.

$$F_1 = \frac{1}{z_N^2} \frac{X(1)}{\sqrt{\sum_{i=2}^{z_N} X^2(i)}} \tag{5}$$

Als repräsentativ für die Größe aller Schwingungsanteile wird in der Gleichung (5) der Wurzelwert aus der Summe der Quadrate der fouriertransformierten Messwerte der Signalfolge X(i) des Ausgangssignals S des Positionsgebers 7 in der aktuellen Drehstellung herangezogen.

Wenn der zeitliche Verlauf der Signalstörungen Z(t) des aktuellen Ausgangssignals S(t) des Positionsgebers 7 einen Grundschwingungsanteil X(1) für die systematisch schwankenden Signalstörungen aufweist, der sich signifikant von allen übrigen Schwingungsanteilen der Signalstörungen unterscheidet, insbesondere wenn die zweite Bewertungskenngröße $F_1$ einen Wert von $\geq 0{,}5$ annimmt, kann die zweite Verfahrensart zum erfindungsgemäß durchzuführenden Vergleich ausgewählt werden.

Wenn sich weder der zeitliche Verlauf der Signalstörungen Z(t) des aktuellen Ausgangssignals S(t) des Positionsgebers 7 signifikant von dem Basis-Grundsignal SG mit zeitlich ausschließlich zufällig schwankenden Signalstörungen unterscheidet ($F_\phi \approx 1$), noch einen Grundschwingungsanteil X(1) der systematisch schwankenden Signalstörungen aufweist, der sich signifikant von allen übrigen Schwingungsanteilen X(i) der Signalstörungen Z(t) unterscheidet ($F_1 \ll 0{,}5$), kann eine Veränderung der Einsatzbedingungen des inkrementellen Positionsgebers 7 erfolgen, oder es muss, wenn dies beispielsweise bei einer im Rahmen der Endabnahme des Motors 1 erfolgenden Aufnahme und Speicherung der Referenzfolge y(i) detektiert wird, ein Austausch gegen einen anderen Positionsgeber 7 erfolgen. Eine reine Schrägstellung des Geberrades 5 relativ zur Sensorelektronik 6 würde lediglich die Amplituden der beiden Teilsignale S1, S2 zueinander verschieben. In einem solchen Geber 7, in dem durch eine Variation z. B. der Zahnhöhen gezielt Störungen in den Signalverlauf eingebracht sind, dürfen jedoch die resultierenden Signale S(t) nur soweit schwanken, dass für die nachfolgende Winkelberechnung eine vollständige Kompensation noch möglich bleibt und die Auflösung nicht beeinträchtigt wird.

Nach der ersten Verfahrensart zum Vergleich des zeitlichen Verlaufs des Anteils der systematisch schwankenden Signalstörungen Z(t) der Messwerte der aktuellen Signalfolge x(i) mit dem zeitlichen Verlauf des Anteils der systematisch schwankenden Signalstörungen Z(t) aus den Messwerten der ausgehend von der Referenz-Ausgangsdrehstellung O gewonnenen Signalfolge y(i) wird aus den Messwerten der Signalfolgen x(i), y(i) nach Gleichung (6) eine Kreuzkorrelationsfunktion $\Phi_{x,y}$ gebildet:

$$\phi_{x,y}(\tau) = \sum_{i=1}^{n_z} x(i) \cdot y(i+\tau) \tag{6}$$

Die Abszissenwerte der Kreuzkorrelationsfunktion $\Phi_{x,y}(T)$ der Signalfolgen x(i), y(i) werden dabei durch Multiplikation des Wertes eines zeitlichen Inkrements mit einer Anzahl von Inkrementen gebildet, die dem jeweiligen Messwert in einer Signalfolge zugeordnet ist. Die aktuelle Ausgangsdrehstellung A in ihrer Relation zur Referenz-Ausgangsdrehstellung O, die insbesondere initial auf 0 festgelegt werden kann, kann aus der Kreuzkorrelationsfunktion $\Phi_{x,y}(T)$ als ein Versatz $n_{z,offs}$ bestimmt werden, welches sich aus dem Abszissenwert $T$ des Maximums der Kreuzkorrelationsfunktion $\Phi_{x,y}(T)$ ergibt.

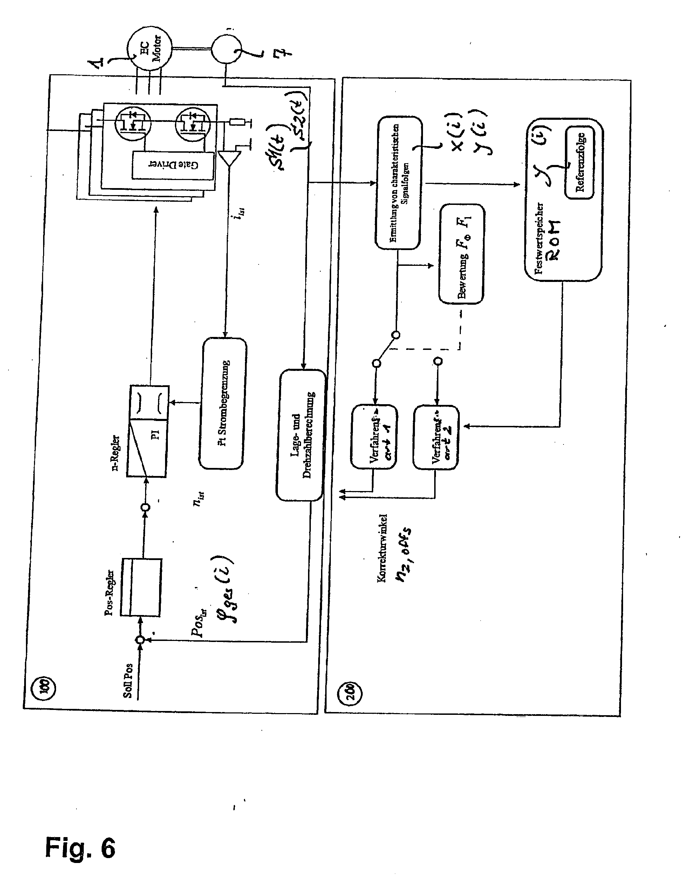

Der Winkelversatz in Grad zwischen der aktuellen Ausgangsdrehstellung A und der Referenz-Ausgangsdrehstellung O des Rotors 2 kann dabei als Produkt aus der Winkelgeschwindigkeit w des Rotors 2 und dem Abszissenwert $T$ des Maximums der Kreuzkorrelationsfunktion $\Phi_{x,y}(T)$ bestimmt werden. Hierzu kann mit der an einem Regler ("n-Regler" in Fig. 6) eingestellten, vorgegebenen Drehzahl gerechnet werden oder auch eine ausschließlich aus dem zeitlichen Verlauf der Signalfolge x(i) des aktuellen Ausgangssignals S(t) des Positionsgebers 7 nach bekannter Art bestimmte aktuelle Winkelgeschwindigkeit w des Rotors 2 herangezogen werden.

Nach der zweiten Verfahrensart zum Vergleich des zeitlichen Verlaufs des Anteils der systematisch schwankenden Signalstörungen Z(t) der Messwerte der aktuellen Signalfolge x(i) mit dem zeitlichen Verlauf des Anteils der systematisch schwankenden Signalstörungen Z(t) aus den Messwerten der ausgehend von der Referenz-Ausgangsdrehstellung O gewonnenen Signalfolge y(t) wird aus den Messwerten der Signalfolgen x(t), y(t) insbesondere nach einer Fouriertransformation der Messwerte, die aktuelle Ausgangsdrehstellung A in ihrer Relation zur Referenz-Ausgangsdrehstellung O als Winkelversatz $n_{z,off}$ bestimmt, welches sich aus einer Differenz der Phasenlagen der Grundschwingungsanteile der Signalfolgen x(i), y(i) ergibt. Der Winkelversatz $n_{z,off}$ kann dabei nach Gleichung (7) berechnet werden:

$$n_{z,offs} = \mathrm{int}\left( \frac{\arg(Y(1)) - \arg(X(1))}{2\pi} n_z \right) \tag{7}$$

Ein Vergleich der beiden Verfahrensarten - angewandt auf charakteristische Signalfolgen x(i), y(i) mit unterschiedlichen Rausch- und Sinusanteilen - zeigt, dass bei hohem Grundschwingungsanteil die Signifikanz der Ergebnisse entsprechend dem Wert der Bewertungskenngröße F1 steigt, die Signifikanz der Ergebnisse entsprechend dem Wert der Bewertungskenngröße $F_\phi$ dafür jedoch abnimmt und umgekehrt. Daher ist es besonders vorteilhaft, beide Verfahrensarten wie vorstehend unter Bezugnahme auf Fig. 3 beschrieben miteinander zu kombinieren.

Fig. 6 zeigt eine erfindungsgemäße Anordnung, die aus einer Motoransteuerung 100 für einen Kleinmotor 1 und aus einer Signalverarbeitungseinheit 200 gebildet ist, die zur Auswertung einer innerhalb einer Umdrehung des Motors 1 eindeutigen Position A (Bezugszeichen "$Pos_{ist}$") ausschließlich aus den beiden Signalen S1 (t), S2(t) eines Inkrementalgebers 7 dient. Die Ansteuerung 100 enthält dabei eine Ansteuerschaltung, wobei in der Zeichnung symbolhaft eine dreiphasige Brückenendstufe mit "Gate Driver" zur elektronischen Kommutierung dargestellt ist. In der figürlichen Darstellung bezeichnet das Bezugszeichen $i_{ist}$ einen Iststrom, für den eine Strommessung zum Überlastschutz (Bezugszeichen: "i²t Strombegrenzung") vorgenommen wird. Die Schaltung enthält des Weiteren eine die aktuelle Geschwindigkeit bzw. Drehzahl $n_{ist}$ und die aktuelle Position $\varphi_{ges}(i)$ ermittelnde Auswerteeinheit für das Signal S(t) bzw. die Teilsignale S1 (t), S2(t), die aus dem am Motor 1 angebauten Inkrementalgeber 7 kommen, welche durch den Kasten "Lage- und Drehzahlberechnung" symbolisiert wird, sowie einen Drehzahlregler ("n-Regler") und einen dazu überlagerten Positionsregler ("Pos.-regler").

Die Verarbeitungseinheit 200, welche als Auswerteeinheit zur Bestimmung der Nullposition O dient, enthält eine Einheit zur Ermittlung einer für die Signalform des Inkrementalgebers 7 charakteristischen Signalfolge x(i), y(i), eine Speichereinheit ("Festwertspeicher, ROM") für mindestens eine Referenzfolge x(i), eine Einheit zur Bestimmung beiden Bewertungskenngrößen $F_\phi$ und $F_1$ für die charakteristischen Signalfolgen x(i), y(i) und je eine Einheit zur Ermittlung der Referenzlage aus dem Vergleich der charakteristischen aktuell ermittelten Signalfolge x(i) mit mindestens einer im Festwertspeicher hinterlegten Referenzfolge y(i) nach der ersten oder zweiten der beiden vorstehend beschriebenen Verfahrensarten . Die Auswahl des für die Ermittlung der Referenzlage zu verwendenden Verfahrens erfolgt auf Basis der Sigifikanzkriterien $F_\phi$ und $F_1$.

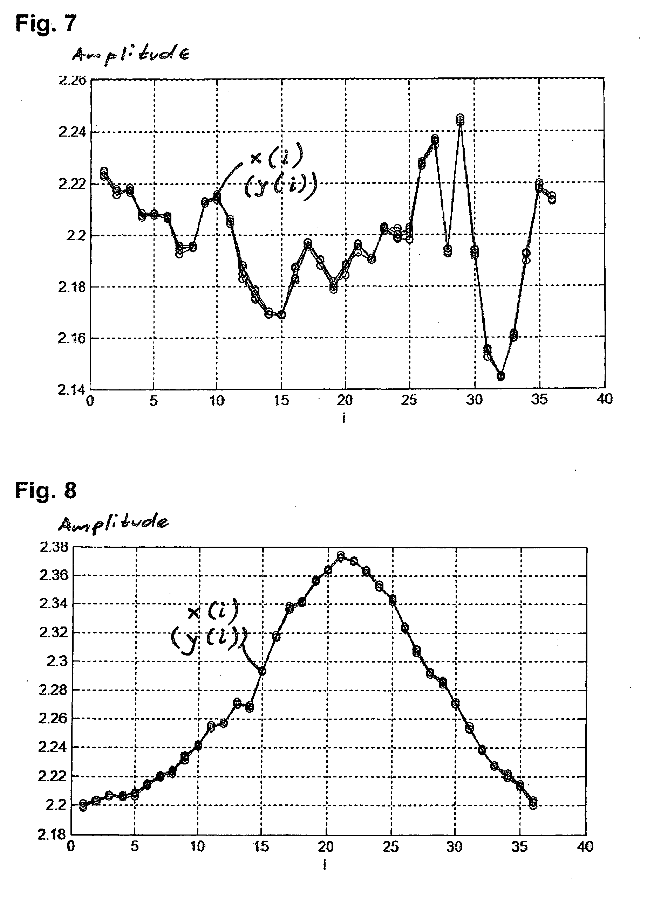

Die Charakteristik von Signalfolgen x(i), y(i) mit unterschiedlichen Rausch- und Sinusanteilen wird dabei durch Fig. 7 bis 15 veranschaulicht.

Fig. 7, 9, 11 und 13 beziehen sich dabei auf einen ersten exemplarischen zeitlichen Verlauf von Messwerten in einer Signalfolge x(i) - und auch y(i) - eines Ausgangssignals S(t) eines in dem erfindungsgemäßen Verfahren eingesetzten inkrementellen Positionsgebers 7. Dieser Messwertverlauf, auf den insbesondere die erste Verfahrensart anwendbar ist, zeigt einen hohen Rauschanteil im Signal S(t) an. Er verdeutlicht die charakteristische Signalfolge eines Positionsgebers 7 mit dominierendem Anteil der nicht korrelierten, zufälligen aber für das gewählte Gebersystem 7 charakteristisch reproduzierbaren Veränderungen der Signalamplituden, die z. B. durch Helligkeitsschwankungen einer Reflexscheibe oder durch zufällige Magnetfeldschwankungen eines magnetischen Gebersystems 7 hervorgerufen werden. Die erste Bewertungskenngröße $F_\phi$ nimmt darin einen Wert von 1,7 an.

Fig. 8, 10, 12, 14 und 15 beziehen sich auf einen zweiten exemplarischen Messwertverlauf in den Signalfolgen x(i), y(i), der einen hohen Sinusanteil im Signal S(t) aufweist und auf den daher insbesondere die zweite Verfahrensart anwendbar ist, da die erste Bewertungskenngröße $F_\phi$ darin nur einen Wert von 1,02 annimmt. Die Amplitude dieser Sinusschwingung ist näherungsweise proportional zum über eine Umdrehung schwankenden Abstand zwischen Geberrad 5 und Sensorelektronik 6, wie er durch ein schräg eingebautes Geberrad 5 erzielt werden kann.

Die jeweils in Fig. 7 bis 10 und Fig. 13 und 14 gezeigten unterschiedlichen Kurvenverläufe beziehen sich dabei auf verschiedene Messwerttemperaturen. Abhängig von der Temperatur der Anordnung kann sich die Signalcharakteristik, z. B. durch eine über der Temperatur veränderliche Empfindlichkeit des verwendeten Sensors, verändern. Es kann daher vorgesehen werden, im Betrieb des Antriebs, abhängig von der Temperatur des Antriebs, weitere Referenzfolgen y(i) durch Auswertung der herangezogenen Signalcharakteristika zu ermitteln und in dem nichtflüchtigen Speicher ROM als zusätzliche Referenzen abzuspeichern.

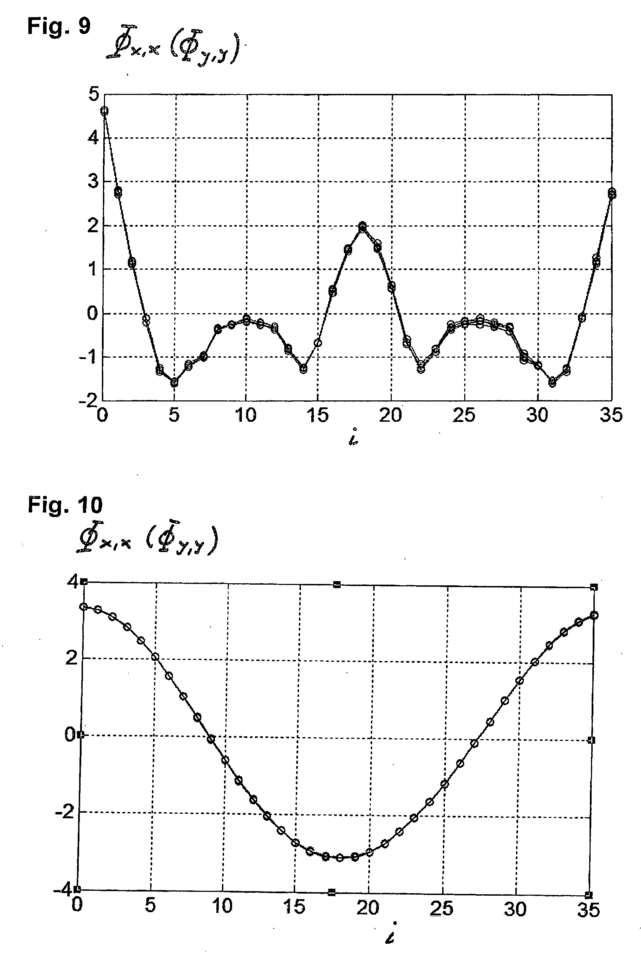

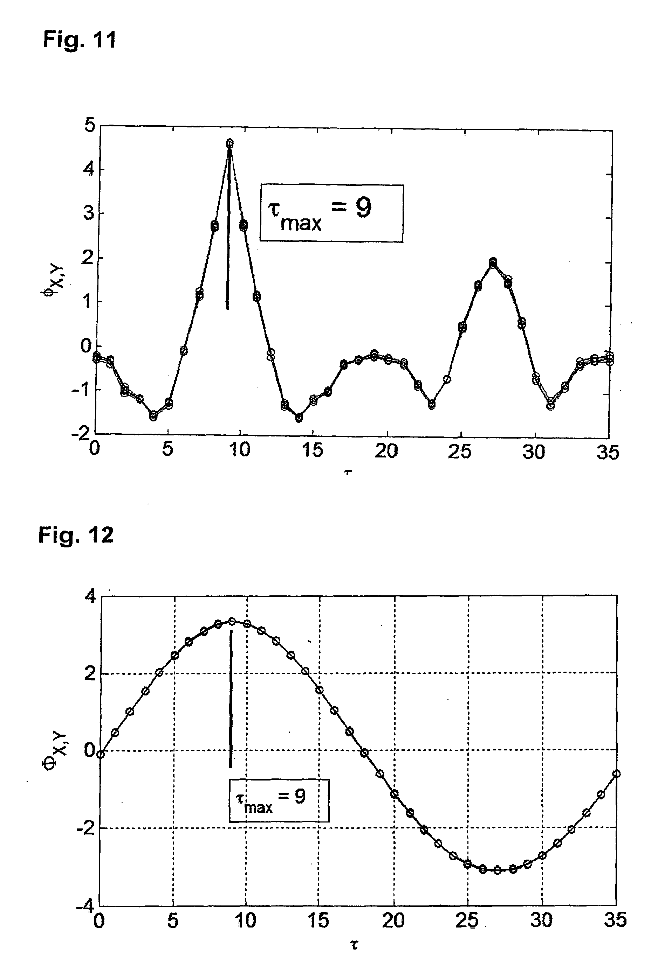

In Fig. 7 bis 10 sind dabei, wie auch in Fig. 4 und 5, die entsprechenden Ordinatenwerte über der laufenden Zähnezahl i ($1 \leq i \leq n_z = 36$) des Geberrades 5 bzw. der dimensionslosen diskretisierten Abtastgröße gemäß Gleichung (1) aufgetragen. Den Ordinatenwerten der Fig. 7 und 8 sind dabei jeweils die Messwerte der Signalfolgen x(i), y(i) als Amplitudenwerte des Signals S(t) zu entnehmen, während in Fig. 9 und 10 die Werte der Autokorrelationsfunktionen $\Phi_{x,x}$, $\Phi_{y,y}$ und in Fig. 11 und 12 die der Kreuzkorrelationsfunktion $\Phi_{x,y}$ als Ordinatenwerte aufgetragen sind. Die Zähnezahl $n_z$ des Geberrades 5 ist einem bestimmten Winkelwert oder - unter Berücksichtigung einer konstanten Drehzahl bzw. Winkelgeschwindigkeit $\omega$ des Rotors 2 - auch einer bestimmten Zeit t äquivalent. Damit kann auf der Abszisse auch der Wert *T* abgelesen werden, wie dies Fig. 11 und 12 zeigen.

Aus einem Vergleich von Fig. 7 und 8 sowie Fig. 9 und 10 oder auch Fig. 11 und 12 leitet sich ab, dass durch die Anwendung der zweiten Verfahrensart zum erfindungsgemäßen Vergleich ein bei der ersten Verfahrensart auftretender Nachteil vermieden werden kann, wonach bei der Auswertung eine hohe Regelmäßigkeit des entstehenden Verlaufs der charakteristischen Signalfolge x(i), ausgedrückt z. B. durch eine kleine Bewertungskenngröße $F_\phi$, auftritt.

Fig. 11 zeigt die Kreuzkorrelation $\Phi_{X,Y}(\tau)$ einer Signalfolge x(i) nach Fig. 7 bzw. Fig. 9 mit einer demgegenüber um $n_{z,off}$ = 9 Polen (konkret Zähnen 5a) verschobenen Referenzfolge y(i). Aufgrund der deutlichen Signifikanz des globalen Maximums kann der Winkelversatz $n_{z,off}$ hier auch unter dem Einfluss von Messrauschen und ggf. einer Temperaturdrift sicher bestimmt werden.

Fig. 12 zeigt die Kreuzkorrelation $\Phi_{X,Y}(\tau)$ einer Signalfolge x(i) nach Fig. 8 bzw. Fig. 10 mit einer ebenfalls demgegenüber um $n_{z,off}$ = 9 Polen (konkret Zähnen 5a) verschobenen Referenzfolge y(i). Aufgrund der geringen Signifikanz des in diesem Fall einzigen Maximums kann der Winkelversatz $n_{z,off}$ hier unter dem Einfluss von Messrauschen und ggf. einem Temperaturdrift nicht sicher bestimmt werden.

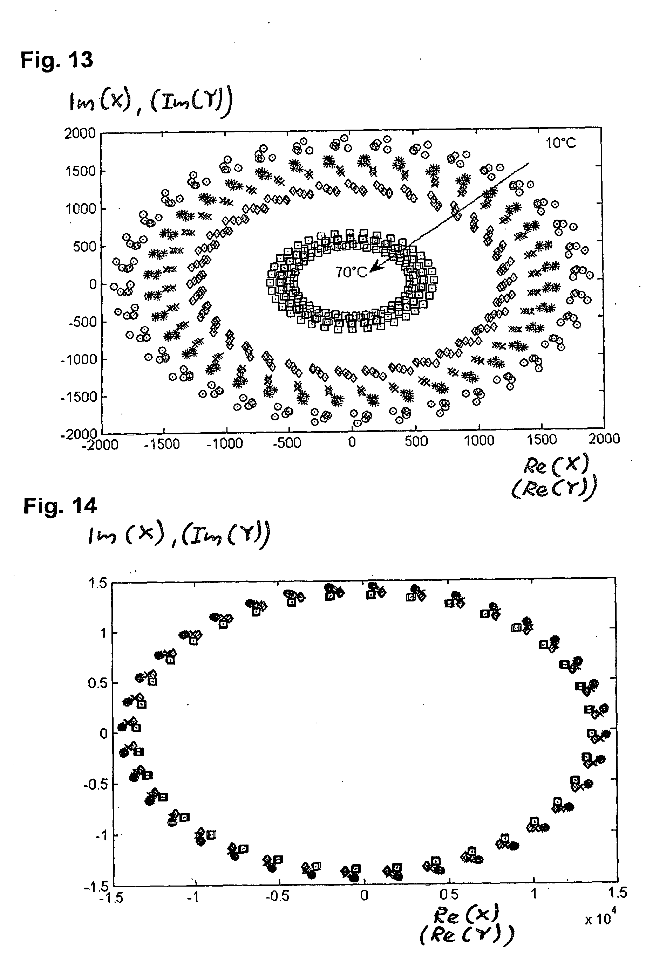

In den in Fig. 13 bis 15 dargestellten Diagrammen der fouriertransformierten Grundschwingungsanteile X(i) bzw. Y(i) in der komplexen Zahlenebene sind die Imaginärteile Im der für die Schwankung der Störungen Z(t) der Messwerte charakteristischen Schwingungen als Ordinate für verschiedene Referenz-Ausgangsdrehstellungen O jeweils über den entsprechenden Realteilen Re als Abszissenwerte mit der Temperatur als Parameter aufgetragen. Dem Wert des Imaginärteils Im entsprechen dabei in Gleichung (7) jeweils die Werte arg X(1) bzw. arg Y(1). Aus einem Vergleich von Fig. 13 und 14 ist dabei zu erkennen, dass bei den Messwerten x(i), die nach der ersten Verfahrensart zum erfindungsgemäßen Vergleich zu verarbeiten sind, eine höhere Temperaturempfindlichkeit zu beachten ist als bei solchen, auf die bevorzugt die zweiten Verfahrensart Anwendung finden kann.

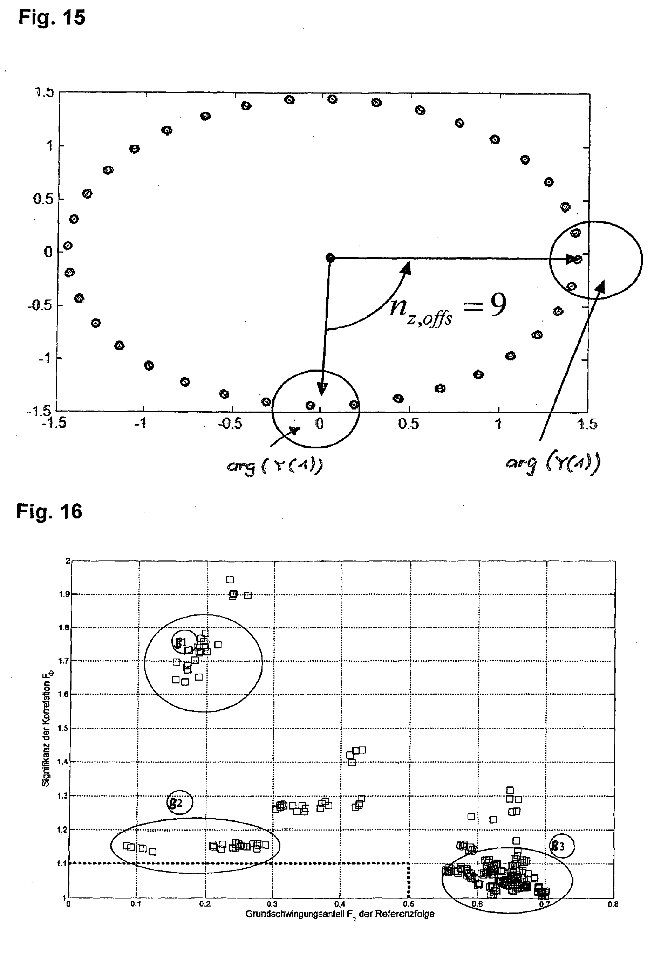

Fig. 15 zeigt die die Winkellagen der Grundschwingungsanteile einer charakteristischen Signalfolge der Art nach Fig. 8, 10, 12 und 14 für alle bei $n_z$ = 36 möglichen relativen Lagen zwischen der aktuellen charakteristischen Folge x(i) und der im Festwertspeicher ROM hinterlegten Referenzfolge y(i). Eingezeichnet ist zusätzlich symbolisch auch, dass nach Gleichung (7) daraus die Ermittlung des Versatzes $n_{z,offs}$ gegenüber der Referenzlage O durch Vergleich der Argumente des Grundschwingungsanteils der Referenzlage arg(FFT(Y)(1)) und des Grundschwingungsanteils arg(FFT(X)(1)) der aktuell bestimmten charakteristischen Signalfolge x(i) vorgenommen werden kann.

Fig. 16 zeigt in einer Felddarstellung die beiden Bewertungskenngrößen $F\phi$ und F1 für die Signifikanz der Messwertfolgen x(i), y(i) verschiedener Inkrementalgeber 7 gleicher Bauart, aber mit je unterschiedlichen Größen der zufällig schwankenden Anteile Z(t) der Messwertfolgen, wie sie extremal in Fig. 7 dargestellt sind, bzw. mit je unterschiedlichen Größen der harmonischen Schwingungsanteile Z(t) der Folgen, wie sie extremal in Fig. 8 dargestellt sind.

In dem mit dem Bezugszeichen B1 gekennzeichneten Bereich liegen Geber 7, deren Charakteristiken der Folge aus Fig. 7 mit deutlich zufällig schwankenden Signalanteilen ähnlich ist, wobei sie keinen nennenswerten signifikanten Grundschwingungsanteil aufweisen. Die Ermittlung des Winkelversatzes $n_{z,offs}$ zwischen der charakteristischen Folge x(i) und der Referenzfolge y(i) ist hier über die Kreuzkorrelationsfunktion $\Phi_{x,y}$ entsprechend Gleichung (6) in Verbindung mit Fig. 11 zuverlässig möglich.

Im mit B2 bezeichneten Bereich liegen Geber, die Messwertfolgen x(i), y(i) liefern, die ebenfalls einen nahezu verschwindenden Grundschwingungsanteil aufweisen, aber gleichzeitig auch gegenüber dem Bereich B1 einen deutlich niedrigeren zufällig schwankenden Anteil der Signalstörungen Z(t). Solange das Verhältnis $F_\Phi$ des Maximums - ausgedrückt als Verhältnis zwischen dem Wert der Autokorrelationsfunktion $\Phi_{y,y}$ bei $\tau$ = 0 bezogen auf den nächst größten Wert der Autokorrelationsfunktion $\Phi_{y,y}$ - hier mit $F_\Phi$ > 1,1 jedoch noch deutlich über dem Einfluss der Messunsicherheit für die Elemente der Messwertfolge x(i), y(i) liegt, ist eine eindeutige Bestimmung des Winkelversatzes $n_{z,offs}$ auch in diesem Bereich über die Kreuzkorrelationsfunktion $\Phi_{x,y}$ zwischen der charakteristischen Folge x(i) und der Referenzfolge y(i) zuverlässig möglich.

Der Bereich B3 kennzeichnet Signalfolgen x(i), y(i) mit einem vergleichsweise hohen Grundschwingungsanteil (> 50%), was sich in einem entsprechenden Wert der zweiten Bewertungskenngröße $F_1$ ausdrückt. Allerdings zeigt der Wert der ersten Bewertungskenngröße $F_\Phi$ an, dass die Signalfolgen x(i), y(i) hier keine ausreichende Signifikanz mehr im Sinne des in Fig. 7 dargestellten Signalverlaufs aufweisen. Abhängig von einem möglichen Messrauschen der Anordnung und einer eventuellen Temperaturdrift ist daher eine eindeutige Ermittlung des Winkelversatzes $n_{z,offs}$ über die Kreuzkorrelationsfunktion $\Phi_{x,y}$ hier nicht mehr möglich. Stattdessen kann der Winkelversatz $n_{z,offs}$ aber hier über den Vergleich der Winkellagen der Grundschwingungsanteile der charakteristischen Folge X bzw. der Referenzfolge Y entsprechend Gleichung (7) ermittelt werden.

Die Erfindung ist bislang noch nicht auf die in den unabhängigen Ansprüchen definierten Merkmalskombinationen beschränkt, sondern kann auch durch jede beliebige andere Kombination von bestimmten Merkmalen aller insgesamt offenbarten Einzelmerkmalen definiert sein. Dies bedeutet, dass grundsätzlich jedes Einzelmerkmal der unabhängigen Ansprüche weggelassen bzw. durch mindestens ein an anderer Stelle der Anmeldung offenbartes Einzelmerkmal ersetzt werden kann. Insofern sind die Ansprüche lediglich als ein erster Formulierungsversuch für eine Erfindung zu verstehen.

Wie bereits aus den vorstehenden Ausführungen hervorgeht, ist die Erfindung auch nicht auf die dargestellten Ausführungsbeispiele beschränkt, sondern der Fachmann kann diese bedarfsweise durch weitere zweckmäßige technische Maßnahmen ergänzen oder modifizieren, ohne dass der Rahmen der Erfindung verlassen wird. So können - wie bereits angedeutet - als inkrementelle Positionsgeber 7 beispielsweise induktive, magnetoresistive, optische oder Hall-Sensoren eingesetzt werden. An die Stelle der Zähnezahl $n_z$ tritt in diesem Fall die Anzahl der Pole einer dem Geberrad 5 entsprechenden Einrichtung.

**Patentansprüche**

1. Verfahren zur Detektierung des dynamischen Zustands eines Elektromotors, (1) welcher einen Stator und einen Rotor (2) aufweist, insbesondere eines bürstenlosen, elektronisch kommutierten Gleichstrom-Servokleinmotors, umfassend innerhalb einer Umdrehung des Rotors (2) eindeutige Bestimmungen von Drehstellungen des Rotors (2), und zwar einer aktuellen Drehstellung ($\varphi_{ges}$) relativ zu einer aktuellen Ausgangsdrehstellung (A) sowie dieser aktuellen Ausgangsdrehstellung (A) relativ zu einer Referenz-Ausgangsdrehstellung (O), wobei ein inkrementeller Positionsgeber (7) eingesetzt wird, welcher für eine Anzahl von Inkrementen innerhalb einer Umdrehung des Rotors (2) jeweils ein Ausgangssignal (S) abgibt, das durch Superposition eines Basis-Grundsignals (SG) mit zeitlich zufällig und systematisch schwankenden Signalstörungen (Z) entsteht, wobei das Basis-Grundsignal (SG) aus mindestens zwei, jeweils entsprechend der Drehstellung des Rotors (2) sich periodisch verändernden Teilsignalen (S1, S2) besteht, welche in einer festen Winkelbeziehung zueinander stehen, wobei die Ermittlung der aktuellen Ausgangsdrehstellung (A) ausschließlich aus dem Ausgangssignal (S) des Positionsgebers (7) erfolgt und durch einen Vergleich des zeitlichen Verlaufs des Anteils der systematisch schwankenden Signalstörungen (Z) von Messwerten einer aktuellen Signalfolge (x(i)) mit einem zeitlichen Verlauf des Anteils der systematisch schwankenden Signalstörungen (Z) von Messwerten einer ausgehend von der Referenz-Ausgangsdrehstellung (O) gewonnenen Signalfolge (y(i)) des Ausgangssignals (S) des Positionsgebers (7) ermittelt wird.

2. Verfahren nach Anspruch 1,
   **dadurch gekennzeichnet, dass** der zeitliche Verlauf der Signalstörungen (Z) des Ausgangssignals (S) vor einer weiteren Signalverarbeitung durch eine Mittelwertbildung aus den Messwerten der Signalfolgen (x(i), y(i)) des Ausgangssignals (S) und Subtraktion des Mittelwertes von den Messwerten der Signalfolgen (x(i), y(i)) aus den Signalfolgen (x(i), y(i)) extrahiert wird.

3. Verfahren nach Anspruch 1 oder 2,
   **dadurch gekennzeichnet, dass** die Messwerte der ausgehend von der Referenz-Ausgangsdrehstellung (O) gewonnenen Signalfolge (y(i)) und gegebenenfalls der Signalstörungen (Z) des Ausgangssignals (S) des Positionsgebers (7) nach einer initialen, z. B. bei einer Endprüfung nach der Fertigung des Elektromotors (1) festgelegten, Ausrichtung des Rotors (2) in einer Vorzugsdrehstellung (O) oder durch Kopplung mit einem externen Referenzgeber ermittelt und in einem nichtflüchtigen Speicher (ROM) niedergelegt werden.

4. Verfahren nach Anspruch 3,
   **dadurch gekennzeichnet, dass** die Messwerte der ausgehend von der Referenz-Ausgangsdrehstellung (O) gewonnenen Signalfolge (y(i)) und gegebenenfalls der Signalstörungen (Z) des Ausgangssignals (S) des Positionsgebers (7) bei mehreren unterschiedlichen Temperaturen ermittelt und in dem nichtflüchtigen Speicher (ROM) niedergelegt werden.

5. Verfahren nach einem der Ansprüche 1 bis 4,
   **dadurch gekennzeichnet, dass** die Teilsignale (S1, S2) sich jeweils entsprechend der Drehstellung des Rotors (2) nach einer harmonischen Winkelfunktion verändern.

6. Verfahren nach einem der Ansprüche 1 bis 5,
   **dadurch gekennzeichnet, dass** aus den Signalfolgen (x(i), y(i)) des zeitlichen Verlaufs der Signalstörungen (Z) des Ausgangssignals (S) des Positionsgebers (7) ausgehend von der Referenz-Ausgangsdrehstellung (O) und/oder in der aktuellen Drehstellung ($\varphi_{ges}$) des Rotors (2) jeweils eine Bewertungskenngröße ($F_\Phi$, $F_1$) für die Charakteristik des zeitlichen Verlaufs der Störungen (Z) ermittelt wird, wobei entsprechend einem Wert dieser Bewertungskenngrößen ($F_\Phi$, $F_1$) die Auswahl einer ersten oder einer zweiten Verfahrensart, nach welcher jeweils der Vergleich des zeitlichen Verlaufs des Anteils der systematisch schwankenden Signalstörungen (Z) des aktuellen Ausgangssignals (S) mit dem zeitlichen Verlauf des Anteils der systematisch schwankenden Signalstörungen (Z) des Ausgangssignals (S) des Positionsgebers (7) in der Referenz-Ausgangsdrehstellung (O) vorgenommen wird, oder eine Veränderung der Einsatzbedingungen des inkrementellen Positionsgebers (7) und/oder des inkrementellen Positionsgebers (7) selbst erfolgt.

7. Verfahren nach Anspruch 6,
   **dadurch gekennzeichnet, dass** eine erste Bewertungskenngröße ($F_\Phi$), die aus dem zeitlichen Verlauf der Signalstörungen (Z) des Ausgangssignals (S) des Positionsgebers (7) ausgehend von der Referenz-Ausgangsdrehstellung (O) gewonnen wird, durch einen Vergleich der Signalfolge (y(i)) des zeitlichen Verlaufs der Signalstörungen (Z) des Ausgangssignals (S) des Positionsgebers (7) ausgehend von der Referenz-Ausgangsdrehstellung (O) mit einem zeitlichen Verlauf des Ausgangssignals (S) mit ausschließlich zufällig schwankenden Signalstörungen (Z) gewonnen wird.

8. Verfahren nach Anspruch 7,
   **dadurch gekennzeichnet, dass** ein Positionsgeber (7) mit einer Gebercharakteristik eingesetzt wird, in der konstruktiv ein zeitliche Verlauf der ausschließlich zufällig schwankenden Signalstörungen (Z) des Ausgangssignals (S) entsprechend einer Überlagerung des Grundsignals (SG) mit einem insbesondere binären und/oder über die Pole des Gebers segmentierten Muster und/oder mit einem Pseudorauschsignal, wie insbesondere mit einem weißen Rauschen, eingeprägt ist.

9. Verfahren nach den Ansprüchen 7 und 8,
   **dadurch gekennzeichnet, dass** die erste Bewertungskenngröße ($F_\Phi$), die aus dem zeitlichen Verlauf der Signalstörungen (Z) des Ausgangssignals (S) des Positionsgebers (7) ausgehend von der Referenz-Ausgangsdrehstellung (O) gewonnen wird, als Quotient des globalen Maximalwertes einer aus der Signalfolge (y(i)) des zeitlichen Verlaufs des Ausgangssignals (S) des Positionsgebers (7) ausgehend von der Referenz-Ausgangsdrehstellung (O) gewonnenen Autokorrelationsfunktion ($\Phi_{y,y}$) und des Maximalwertes einer aus der Signalfolge des zeitlichen Verlaufs des Ausgangssignals (S) mit ausschließlich zufällig schwankenden Signalstörungen (Z) gewonnenen Autokorrelationsfuhktion ($\Phi_{y,y}$) gebildet wird.

10. Verfahren nach einem der Anspüche 1 bis 9, insbesondere nach Anspruch 9,
    **dadurch gekennzeichnet, dass**, wenn der zeitliche Verlauf der Signalstörungen (Z) des aktuellen Ausgangssignals (S) des Positionsgebers (7) sich signifikant von einem Basis-Grundsignal mit zeitlich ausschließlich zufällig schwankenden Signalstörungen (Z) unterscheidet, insbesondere wenn die erste Bewertungskenngröße ($F_\Phi$) einen Wert von $\geq 1{,}1$ annimmt, eine erste Verfahrensart ausgewählt wird, nach welcher jeweils der Vergleich des zeitlichen Verlaufs des Anteils der systematisch schwankenden Signalstörungen (Z) des aktuellen Ausgangssignals (S) mit dem zeitlichen Verlauf des Anteils der systematisch schwankenden Signalstörungen (Z) des Ausgangssignals (S) des Positionsgebers (7) in der Referenz-Ausgangsdrehstellung (O) vorgenommen wird.

11. Verfahren nach einem der Ansprüche 1 bis 10,
    **dadurch gekennzeichnet, dass** aus der Signalfolge (x(i)) des zeitlichen Verlaufs der Signalstörungen (Z) des Ausgangssignals (S) des Positionsgebers (7) in der aktuellen Drehstellung und aus der Signalfolge (y(i)) des zeitlichen Verlaufs der Signalstörungen (Z) des Ausgangssignals (S) des Positionsgebers (7) ausgehend von der Referenz-Ausgangsdrehstellung (O), insbesondere jeweils als ein durch Fouriertransformation gewonnener Wert, ein Grundschwingungsanteil bestimmt wird, der für den zeitlichen Verlauf der systematisch schwankenden Signalstörungen (Z) charakteristisch ist.

12. Verfahren nach den Ansprüchen 6 und 11,
    **dadurch gekennzeichnet, dass** eine zweite Bewertungskenngröße ($F_1$), die aus dem zeitlichen Verlauf der Signalstörungen (Z) des Ausgangssignals (S) des Positionsgebers (7) in der aktuellen Drehstellung gewonnen wird, aus einem Vergleich des für die systematisch schwankenden Signalstörungen (Z) charakteristischen Grundschwingungsanteils mit der Größe aller Schwingungsanteile der Signalstörungen (Z) gewonnen wird.

13. Verfahren nach Anspruch 12,
    **dadurch gekennzeichnet, dass** als repräsentativ für die Größe aller Schwingungsanteile der Wurzelwert aus der Summe der Quadrate, der vorzugsweise fouriertransformierten Messwerte (X(i)) der Signalfolge (x(i)) des zeitlichen Verlaufs des Ausgangssignals (S) oder der Signalstörungen (Z) des Ausgangssignals (S) des Positionsgebers (7) in der aktuellen Drehstellung herangezogen wird.

14. Verfahren nach einem der Ansprüche 1 bis 13, insbesondere nach Anspruch 13,
    **dadurch gekennzeichnet, dass**, wenn der zeitliche Verlauf der Signalstörungen (Z) des aktuellen Ausgangssignals (S) des Positionsgebers (7) einen Grundschwingungsanteil für die systematisch schwankenden Signalstörungen (Z) aufweist, der sich signifikant von allen übrigen Schwingungsanteilen der Signalstörungen (Z) unterscheidet, insbesondere wenn die zweite Bewertungskenngröße ($F_1$) einen Wert von $\geq 0{,}5$ annimmt, eine zweite Verfahrensart ausgewählt wird, nach welcher jeweils der Vergleich des zeitlichen Verlaufs des Anteils der systematisch schwankenden Signalstörungen (Z) des aktuellen Ausgangssignals (S) mit dem zeitlichen Verlauf des Anteils der systematisch schwankenden Signalstörungen (Z) des Ausgangssignals (S) des Positionsgebers (7) in der Referenz-Ausgangsdrehstellung (O) vorgenommen wird.

15. Verfahren nach einem der vorhergehenden Ansprüche,
**dadurch gekennzeichnet, dass**, wenn sich weder der zeitliche Verlauf der Signalstörungen (Z) des aktuellen Ausgangssignals (S) des Positionsgebers (7) signifikant von einem Basis-Grundsignal mit zeitlich ausschließlich zufällig schwankenden Signalstörungen (Z) unterscheidet, insbesondere wenn die erste Bewertungskenngröße ($F_\Phi$) einen Wert von gleich 1 annimmt, noch der zeitliche Verlauf der Signalstörungen (Z) des aktuellen Ausgangssignals (S) des Positionsgebers (7) einen Grundschwingungsanteil für die systematisch schwankenden Signalstörungen (Z) aufweist, der sich signifikant von allen übrigen Schwingungsanteilen der Signalstörungen (Z) unterscheidet, insbesondere wenn die zweite Bewertungskenngröße ($F_1$) einen Wert kleiner 0,5 annimmt, eine Veränderung der Einsatzbedingungen des inkrementellen Positionsgebers (7) und/oder des inkrementellen Positionsgebers (7) selbst, wie ein Austausch desselben, erfolgt.

16. Verfahren nach einem der Ansprüche 1 bis 15,
**dadurch gekennzeichnet, dass** nach einer/der ersten Verfahrensart zum Vergleich des zeitlichen Verlaufs des Anteils der systematisch schwankenden Signalstörungen (Z) der Messwerte der aktuellen Signalfolge (x(i)) mit dem zeitlichen Verlauf des Anteils der systematisch schwankenden Signalstörungen (Z) aus den Messwerten der ausgehend von der Referenz-Ausgangsdrehstellung (O) gewonnenen Signalfolge (y(i))aus den Messwerten der Signalfolgen (x(i), y(i)) eine Kreuzkorrelationsfunktion gebildet wird.

17. Verfahren nach Anspruch 16,
**dadurch gekennzeichnet, dass** die aktuelle Ausgangsdrehstellung (A) in ihrer Relation zu einer Referenz-Ausgangsdrehstellung (O) als ein Winkelversatz ($n_{z,offs}$) bestimmt wird, welches sich aus dem Abszissenwert des Maximums der Kreuzkorrelationsfunktion ergibt.

18. Verfahren nach Anspruch 17,
**dadurch gekennzeichnet, dass** die Abszissenwerte der Kreuzkorrelationsfunktion der Signalfolgen (x(i), y(i)) durch Multiplikation des Wertes eines zeitlichen Inkrements mit einer Anzahl von Inkrementen gebildet werden, die dem jeweiligen Messwert in einer Signalfolge (x(i), y(i)) zugeordnet ist.

19. Verfahren nach einem der Ansprüche 1 bis 18,
**dadurch gekennzeichnet, dass** ausschließlich aus dem zeitlichen Verlauf der Signalfolge (x(i)) des aktuellen Ausgangssignals (S) des Positionsgebers (7) eine aktuelle Winkelgeschwindigkeit des Rotors bestimmt wird.

20. Verfahren nach den Ansprüchen 17, 18 und 19,
**dadurch gekennzeichnet, dass** der Winkelversatz ($n_{z,offs}$) zwischen der aktuellen Ausgangsdrehstellung (A) und der Referenz-Ausgangsdrehstellung (O) des Rotors als Produkt aus der Winkelgeschwindigkeit des Rotors und dem Abszissenwert des Maximums der Kreuzkorrelationsfunktion bestimmt wird.

21. Verfahren nach Anspruch 11,
**dadurch gekennzeichnet, dass** nach einer/der zweiten Verfahrensart zum Vergleich des zeitlichen Verlaufs des Anteils der systematisch schwankenden Signalstörungen (Z) der Messwerte der aktuellen Signalfolge(x(i)) mit dem zeitlichen Verlauf des Anteils der systematisch schwankenden Signalstörungen (Z) aus den Messwerten der ausgehend von der Referenz-Ausgangsdrehstellung (O) gewonnenen Signalfolge (y(i)) aus den Messwerten der Signalfolgen (x(i), y(i)), insbesondere nach einer Fouriertransformation der Messwerte, die aktuelle Ausgangsdrehstellung (A) in ihrer Relation zu einer Referenz-Ausgangsdrehstellung als Winkelversatz ( $n_{z,offs}$) bestimmt wird, welches sich aus einer Differenz der Phasenlagen der Grundschwingungsanteile der Signalfolgen (x(i), y(i)) ergibt.

22. Verfahren nach einem der Ansprüche 1 bis 21,
**dadurch gekennzeichnet, dass** vor jeder Signalverarbeitung die Anzahl der Messwerte der aktuellen Signalfolge (x(i)) des Ausgangssignals (S) des Positionsgebers (7) mit der Anzahl der Messwerte der ausgehend von der Referenz-Ausgangsdrehstellung (O) gewonnenen Signalfolge (y(i)) des Ausgangssignals (S) des Positionsgebers (7) verglichen wird, und dass, wenn die Anzahl der Messwerte der aktuellen Signalfolge (x(i)) größer ist als die Anzahl der Messwerte der ausgehend von der Referenz-Ausgangsdrehstellung (O) gewonnenen Signalfolge (y(i)), durch einfache oder mehrfache vollständige und/oder teilweise repetitive Anfügung der Messwerte der Signalfolge (y(i)) aus der ausgehend von der Referenz-Ausgangsdrehstellung (O) gewonnenen Signalfolge (y(i)) eine abgeglichene Signalfolge (y*(j)) mit der gleichen Anzahl der Messwerte gebildet wird wie die Anzahl der Messwerte der aktuellen Signalfolge (x(i)).

23. Verfahren nach einem der Ansprüche 1 bis 22,

**dadurch gekennzeichnet, dass** die Anzahl der Inkremente im Bereich von 3000 bis 100000 bezogen auf eine vollständige Umdrehung des Rotors (2) liegt.

24. Verfahren nach einem der Ansprüche 1 bis 23,
**dadurch gekennzeichnet, dass** als inkrementeller Positionsgeber (7) ein induktiver, magnetoresistiver, optischer oder Hall-Sensor eingesetzt wird.

25. Anordnung zur Detektierung des dynamischen Zustands eines Elektromotors (1), insbesondere eines bürstenlosen, elektronisch kommutierten Gleichstrom-Servokleinmotors (1), vorzugsweise zur Durchführung eines Verfahrens nach einem der Ansprüche 1 bis 24, umfassend eine Motoransteuerung (100) für den Elektromotor (1), einen inkrementellen Positionsgeber (7) und eine Signalverarbeitungseinheit (200), wobei die Verarbeitungseinheit (200), welche zu einer innerhalb einer Umdrehung des Rotors (2) des Elektromotors (1) eindeutigen Bestimmung von Drehstellungen des Rotors (2) dient, und zwar einer aktuellen Drehstellung ($\varphi_{ges}$) relativ zu einer aktuellen Ausgangsdrehstellung (A) sowie dieser aktuellen Ausgangsdrehstellung (A) relativ zu einer Referenz-Ausgangsdrehstellung (O), eine Einheit zur Ermittlung einer für ein Signal (S) des Positionsgebers (7) charakteristischen Signalfolge (x(i), y(i)), einen nichtflüchtigen Speicher (ROM) für mindestens eine Referenzfolge x(i) des Signals (S) und zwei Einheiten zur Bestimmung von jeweils einer ersten Bewertungskenngröße ($F_\phi$) oder einer zweiten Bewertungskenngröße ($F_1$) für die Signalfolgen (x(i), y(i)) sowie je eine, jeder Einheit zur Bestimmung der Bewertungskenngrößen ($F_\phi$, $F_1$) zugeordnete Einheit zur Ermittlung eines Winkelversatzes ($n_{z,offs}$) der aktuellen Ausgangsdrehstellung (A) relativ zur Referenz-Ausgangsdrehstellung (O) aus dem Vergleich einer aktuellen Signalfolge x(i) mit mindestens einer im Festwertspeicher (ROM) hinterlegten Referenzfolge y(i) umfasst, wobei die Einheiten zur Ermittlung des Winkelversatzes ($n_{z,offs}$) derart ausgelegt sind, dass die Ermittlung des Winkelversatzes ($n_{z,offs}$) nach jeweils unterschiedlichen Verfahrensarten der Signalverarbeitung der aktuellen Signalfolge x(i) erfolgt.

26. Anordnung nach Anspruch 25,
**gekennzeichnet durch** Bauelemente zur Realisierung der Verfahrensmerkmale des Kennzeichens eines oder mehrerer der Ansprüche 1 bis 24.

## Claims

1. Method for detecting the dynamic state of an electric motor (1) which has a stator and a rotor (2), in particular of a brushless, electronically commutated direct-current small servomotor, comprising unambiguous determinations of rotational positions of the rotor (2) within one revolution of the rotor (2), specifically of a current rotational position ($\varphi_{total}$) relative to a current initial rotational position (A) as well as of this current initial rotational position (A) relative to a reference initial rotational position (0), wherein an incremental position encoder (7) is used which respectively outputs an output signal (S) for a number of increments within one revolution of the rotor (2), which output signal (S) arises from superposition of a basic signal (SG) with chronologically randomly and systematically fluctuating signal interference (Z), wherein the basic signal (SG) is composed of at least two component signals (S1, S2) which change periodically in each case in accordance with the rotational position of the rotor (2) and are in a fixed angular relationship with one another, wherein the current initial rotational position (A) is determined exclusively from the output signal (S) of the position encoder (7) and is determined by comparing the time profile of the portion of the systematically fluctuating signal interference (Z) of measured values of a current signal sequence (x(i)) with a time profile of the portion of the systematically fluctuating signal interference (Z) of measured values of a signal sequence (y(i)), acquired starting from the reference initial rotational position (0), of the output signal (S) of the position encoder (7).

2. Method according to claim 1,
**characterised in that** the time profile of the signal interference (Z) of the output signal (S) is extracted from the signal sequences (x(i), y(i)) before further signal processing by forming mean values from the measured values of the signal sequences (x(i), y(i)) of the output signal (S) and subtracting the mean value from the measured values of the signal sequences (x(i), y(i)).

3. Method according to claim 1 or 2,
**characterised in that** the measured values of the signal sequence (y(i)), acquired starting from the reference initial rotational position (0), and, if appropriate, of the signal interference (Z) of the output signal (S) of the position encoder (7) are determined after an initial orientation of the rotor (2), defined for example during final testing after the fabrication of the electric motor (1), in a preferred rotational position (0) or by coupling to an external reference encoder, and are stored in a non-volatile memory (ROM).

4. Method according to claim 3,
**characterised in that** the measured values of the signal sequence (y(i)), acquired starting from the reference initial rotational position (0) and, if appropriate, of the signal interference (Z) of the output signal (S) of the position encoder (7) are determined at a plurality of different temperatures and stored in the non-volatile memory (ROM).

5. Method according to one of claims 1 to 4,
**characterised in that** the component signals (S1, S2) each change in accordance with the rotational position of the rotor (2) according to a harmonic angular function.

6. Method according to one of claims 1 to 5,
**characterised in that** in each case an evaluation characteristic variable ($F_\Phi$, $F_1$) for the characteristic of the time profile of the interference (Z) is determined from the signal sequences (x(i), y(i)) of the time profile of the signal interference (Z) of the output signal (S) of the position encoder (7) starting from the reference initial rotational position (0) and/or in the current rotational position ($\varphi_{total}$) of the rotor (2), wherein in accordance with a value of these evaluation characteristic variables ($F_\Phi$, $F_1$) the selection is made of a first or of a second method type, according to which in each case the time profile of the portion of the systematically fluctuating signal interference (Z) of the current output signal (S) is compared with the time profile of the portion of the systematically fluctuating signal interference (Z) of the output signal (S) of the position encoder (7) in the reference initial rotational position (0), or a change takes place in the conditions of use of the incremental position encoder (7) and/or in the incremental position encoder (7) itself.

7. Method according to claim 6,
**characterised in that** a first evaluation characteristic variable ($F_\Phi$) which is acquired from the time profile of the signal interference (Z) of the output signal (S) of the position encoder (7) starting from the reference initial rotational position (0), is acquired by comparing the signal sequence (y(i)) of the time profile of the signal interference (Z) of the output signal (S) of the position encoder (7) starting from the reference initial rotational position (0) with a time profile of the output signal (S) with exclusively randomly fluctuating signal interference (Z).

8. Method according to claim 7,
**characterised in that** a position encoder (7) is used with an encoder characteristic in which a time profile of the exclusively randomly fluctuating signal interference (Z) of the output signal (S) is impressed structurally in accordance with superimposition of a pattern which is, in particular, binary and/or segmented over the poles of the encoder and/or of a pseudo noise signal, such as, in particular, white noise, on the basic signal (SG).

9. Method according to claims 7 and 8,
**characterised in that** the first evaluation characteristic variable ($F_\Phi$), which is acquired from the time profile of the signal interference (Z) of the output signal (S) of the position encoder (7) starting from the reference initial rotational position (O), is formed as a quotient of the global maximum value of an auto-correlation function ($\Phi_{y,y}$), acquired from the signal sequence (y(i)) of the time profile of the output signal (S) of the position encoder (7) starting from the reference initial rotational position (O), and of the maximum value of an auto-correlation function ($\Phi_{y,y}$) acquired from the signal sequence of the time profile of the output signal (S) with exclusively randomly fluctuating signal interference (Z).

10. Method according to one of claims 1 to 9, in particular according to claim 9,
**characterised in that** if the time profile of the signal interference (Z) of the current output signal (S) of the position encoder (7) differs significantly from a basic signal with signal interference (Z) which fluctuates chronologically in an exclusively random way, in particular if the first evaluation characteristic variable ($F_\Phi$) assumes a value of $\geq 1.1$, a first method type is selected according to which in each case the time profile of the portion of the systematically fluctuating signal interference (Z) of the current output signal (S) is compared with the time profile of the portion of the systematically fluctuating signal interference (Z) of the output signal (S) of the position encoder (7) in the reference initial rotational position (0).

11. Method according to one of claims 1 to 10,
**characterised in that** a basic oscillation portion which is characteristic of the time profile of the systematically fluctuating signal interference (Z) is determined, in particular, in each case as a value acquired by Fourier transformation from the signal sequence (x(i)) of the time profile of the signal interference (Z) of the output signal (S) of the position encoder (7) in the current rotational position, and from the signal sequence (y(i)) of the time profile of the signal interference (Z) of the output signal (S) of the position encoder (7) starting from the reference initial rotational position (0).

12. Method according to claims 6 and 11,
**characterised in that** a second evaluation characteristic variable ($F_1$), which is acquired from the time profile of the signal interference (Z) of the output signal (S) of the position encoder (7) in the current rotational position, is acquired from a comparison of the basic oscillation portion, characteristic of the systematically fluctuating signal interference (Z), with the variables of all the oscillation portions of the signal interference (Z).

13. Method according to claim 12,
**characterised in that** the root value of the sum of the squares of the preferably Fourier-transformed measured values (X(i)) of the signal sequence (x(i)) of the time profile of the output signal (S) or of the signal interference (Z) of the output signal (S) of the position encoder (7) in the current rotational position is used as representative of the variables of all the oscillation portions.

14. Method according to one of claims 1 to 13, in particular according to Claim 13,
**characterised in that** if the time profile of the signal interference (Z) of the current output signal (S) of the position encoder (7) has a basic oscillation portion for the systematically fluctuating signal interference (Z) which differs significantly from all the other oscillation portions of the signal interference (Z), in particular if the second evaluation characteristic variable ($F_1$) assumes a value of $\geq 0.5$, a second method type is selected according to which, in each case, the time profile of the portion of the systematically fluctuating signal interference (Z) of the current output signal (S) is compared with the time profile of the portion of the systematically fluctuating signal interference (Z) of the output signal (S) of the position encoder (7) in the reference initial rotational position (0).

15. Method according to one of the preceding claims,
**characterised in that** if neither the time profile of the signal interference (Z) of the current output signal (S) of the position encoder (7) differs significantly from a basic signal with signal interference (Z) which fluctuates chronologically in an exclusively random way, in particular if the first evaluation characteristic variable ($F_\Phi$) assumes a value of equal to 1, nor the time profile of the signal interference (Z) of the current output signal (S) of the position encoder (7) has a basic oscillation portion for the systematically fluctuating signal interference (Z) which differs significantly from all the other oscillation portions of the signal interference (Z), in particular if the second evaluation characteristic variable ($F_1$) assumes a value of less than 0.5, a change takes place in the conditions of use of the incremental position encoder (7) and/or in the incremental position encoder (7) itself, such as a replacement thereof.

16. Method according to one of claims 1 to 15,
**characterised in that** according to a method type/the first method type for comparing the time profile of the portion of the systematically fluctuating signal interference (Z) of the measured values of the current signal sequence (x(i)) with the time profile of the portion of the systematically fluctuating signal interference (Z) composed of the measured values of the signal sequence (y(i)) acquired starting from the reference initial rotational position (0), a cross-correlation function is formed from the measured values of the signal sequences (x(i), y(i)).

17. Method according to claim 16,
**characterised in that** the current initial rotational position (A) is determined in its relationship with a reference initial rotational position (0) as an angular offset ($n_{z,offs}$) which is obtained from the abscissa value of the maximum of the cross-correlation function.

18. Method according to claim 17,
**characterised in that** the abscissa values of the cross-correlation function of the signal sequences (x(i), y(i)) are formed by multiplying the value of a time increment with a number of increments, which number is assigned to the respective measured value in a signal sequence (x(i), y(i)).

19. Method according to one of claims 1 to 18,
**characterised in that** a current angular speed of the rotor is determined exclusively from the time profile of the signal sequence (x(i)) of the current output signal (S) of the position encoder (7).

20. Method according to claims 17, 18 and 19,
**characterised in that** the angular offset ($n_{z,offs}$) between the current initial rotational position (A) and the reference initial rotational position (0) of the rotor is determined as a product of the angular speed of the rotor and the abscissa value of the maximum of the cross-correlation function.

**21.** Method according to claim 11,
**characterised in that** according to a method type/the second method type for comparing the time profile of the portion of the systematically fluctuating signal interference (Z) of the measured values of the current signal sequence (x(i)) with the time profile of the portion of the systematically fluctuating signal interference (Z) composed of the measured values of the signal sequence (y(i)) acquired starting from the reference initial rotational position (0), the current initial rotational position (A) is determined in terms of its relationship with a reference initial rotational position from the measured values of the signal sequences (x(i), y(i)), in particular according to a Fourier transformation of the measured values, as an angular offset ($n_{z,offs}$) which is obtained from a difference between the phase positions of the basic oscillation portions of the signal sequences (x(i), y(i)).

**22.** Method according to one of claims 1 to 21,
**characterised in that** before any signal processing the number of measured values of the current signal sequence (x(i)) of the output signal (S) of the position encoder (7) is compared with the number of measured values of the signal sequence (y(i)), acquired starting from the reference initial rotational position (0), of the output signal (S) of the position encoder (7), and **in that** if the number of measured values of the current signal sequence (x(i)) is greater than the number of measured values of the signal sequence (y(i)) acquired starting from the reference initial rotational position (0), an adjusted signal sequence (y*(j)) with the same number of measured values as the number of measured values of the current signal sequence (x(i)) is formed by single or multiple complete and/or partial repetitive appending of the measured values to the signal sequence (y(i)) from the signal sequence (y(i)) acquired starting from the reference initial rotational position (0).

**23.** Method according to one of claims 1 to 22,
**characterised in that** the number of increments is in the range from 3000 to 100,000 with respect to one complete revolution of the rotor (2).

**24.** Method according to one of claims 1 to 23,
**characterised in that** an inductive, magneto-resistive, optical or Hall sensor is used as the incremental position encoder (7).

**25.** Arrangement for detecting the dynamic state of an electric motor (1), in particular of a brushless, electronically commutated direct-current small servomotor (1), preferably for carrying out a method according to one of claims 1 to 24, comprising a motor actuation means (100) for the electric motor (1), an incremental position encoder (7) and a signal processing unit (200), wherein the processing unit (200) which is used for unambiguously determining rotational positions of the rotor (2) within one revolution of the rotor (2) of the electric motor (1), specifically a current rotational position ($\varphi_{total}$) relative to a current initial rotational position (A) and this current initial rotational position (A) relative to a reference initial rotational position (0), comprises a unit for determining a signal sequence (x(i), y(i)) which is characteristic of a signal (S) of the position encoder (7), a non-volatile memory (ROM) for at least one reference sequence x(i) of the signal (S), and two units for determining, in each case, a first evaluation characteristic variable ($F_{\Phi}$) or a second evaluation characteristic variable ($F_1$) for the signal sequences (x(i), y(i)) as well as in each case one unit, which is assigned to each unit for determining the evaluation characteristic variables ($F_{\Phi}$, $F_1$) and has the purpose of determining an angular offset ($n_{z,offs}$) of the current initial rotational position (A) relative to the reference initial rotational position (0) from the comparison of a current signal sequence x(i) with at least one reference sequence y(i) which is stored in the read-only memory (ROM), wherein the units for determining the angular offset ($n_{z,offs}$) are configured in such a way that the angular offset ($n_{z,offs}$) is determined according to, in each case, different method types for signal processing of the current signal sequence x(i).

**26.** Arrangement according to claim 25,
**characterised by** components for implementing the method features of the characterising part of one or more of claims 1 to 24.

**Revendications**

**1.** Procédé pour la détection de l'état dynamique d'un moteur électrique (1) présentant un stator et un rotor (2), en particulier d'un petit servomoteur à courant continu sans balai, commuté électroniquement, comprenant, au sein d'une révolution du rotor (2), des déterminations univoques de positions de rotation du rotor (2), à savoir une position de rotation actuelle ($\varphi_{ges}$) par rapport à une position de rotation de départ actuelle (A), ainsi que cette position de rotation de départ actuelle (A) par rapport à une position de rotation de départ de référence (O), un transmetteur de position (7) incrémentiel étant utilisé, lequel émet respectivement un signal de sortie (S) pour un certain nombre d'incréments au sein d'une révolution du rotor (2), lequel signal est formé par superposition d'un signal primaire de base (SG) et des perturbations de signal (Z) temporellement aléatoires et fluctuant systématiquement, le signal primaire de base (SG) se composant d'au moins deux signaux partiels (S1, S2) variant respectivement périodiquement en fonction de la position de rotation du rotor (2), lesquels sont en rapport angulaire fixe l'un par rapport à l'autre, la détermination de la position de rotation de départ actuelle (A) s'effectuant exclusivement à partir du signal de sortie (S) du transmetteur de position (7) et grâce à une comparaison entre la variation dans le temps de la fraction des perturbations de signal (Z) fluctuant systématiquement de valeurs de mesure d'une séquence de signaux (x(i)) actuelle et une variation dans le temps de la fraction des perturbations de signal (Z) fluctuant systématiquement de valeurs de mesure d'une séquence de signaux (y(i)), obtenue en partant de la position de rotation de départ de référence (O), du signal de sortie (S) du transmetteur de position (7).

2. Procédé selon la revendication 1,
   **caractérisé en ce que** la variation dans le temps des perturbations de signal (Z) du signal de sortie (S), avant un traitement de signal suivant, est extraite des séquences de signaux (x(i), y(i)) en formant la valeur moyenne à partir des valeurs de mesure des séquences de signaux (x(i), y(i)) du signal de sortie (S) et en soustrayant la valeur moyenne des valeurs de mesure des séquences de signaux (x(i), y(i)).

3. Procédé selon les revendications 1 ou 2,
   **caractérisé en ce que** les valeurs de mesure de la séquence de signaux (y(i)) obtenue en partant de la position de rotation de départ de référence (O) et, le cas échéant, des perturbations de signal (Z) du signal de sortie (S) du transmetteur de position (7), sont déterminées d'après une orientation initiale du rotor (2), par exemple fixée lors d'un contrôle final après la fabrication du moteur électrique (1) dans une position de rotation privilégiée (O) ou par couplage avec un transmetteur de référence externe, et sont enregistrées dans une mémoire non volatile (ROM).

4. Procédé selon la revendication 3,
   **caractérisé en ce que** les valeurs de mesure de la séquence de signaux (y(i) obtenue en partant de la position de rotation de départ de référence (O) et, le cas échéant, des perturbations de signal (Z) du signal de sortie (S) du transmetteur de position (7), sont déterminées pour plusieurs températures différentes et sont enregistrées dans la mémoire non volatile (ROM).

5. Procédé selon l'une des revendications 1 à 4,
   **caractérisé en ce que** les signaux partiels (S1, S2) varient respectivement conformément à la position de rotation du rotor (2) selon une fonction angulaire harmonique.

6. Procédé selon l'une des revendications 1 à 5,
   **caractérisé en ce que** l'on détermine, à partir des séquences de signaux (x(i), y(i)) de la variation dans le temps des perturbations de signal (Z) du signal de sortie (S) du transmetteur de position (7), en partant de la position de rotation de départ de référence (O) et/ou de la position de rotation actuelle ($\varphi_{ges}$) du rotor (2), respectivement une grandeur caractéristique d'évaluation ($F_\Phi$, $F_1$) pour la caractéristique de la variation dans le temps des perturbations (Z), le choix d'un premier ou d'un second type de procédé étant effectué, en fonction d'une valeur de ces grandeurs caractéristiques d'évaluation ($F_\Phi$, $F_1$), selon lequel on effectue respectivement la comparaison de la variation dans le temps de la fraction des perturbations de signal (Z) fluctuant systématiquement du signal de sortie (S) actuel avec la variation dans le temps de la fraction des perturbations de signal (Z) fluctuant systématiquement du signal de sortie (S) du transmetteur de position (7) dans la position de rotation de départ de référence (O), ou bien une variation des conditions d'utilisation du transmetteur de position (7) incrémentiel et/ou du transmetteur de position (7) incrémentiel lui-même ayant lieu.

7. Procédé selon la revendication 6,
   **caractérisé en ce que** l'on obtient une première grandeur caractéristique d'évaluation ($F\Phi$), laquelle est obtenue à partir de la variation dans le temps des perturbations de signal (Z) du signal de sortie (S) du transmetteur de position (7) en partant de la position de rotation de départ de référence (O), grâce à une comparaison entre la séquence de signaux (y(i)) de la variation dans le temps des perturbations de signal (Z) du signal de sortie (S) du transmetteur de position (7) en partant de la position de rotation de départ de référence (O) et une variation dans le temps du signal de sortie (S) avec exclusivement des perturbations de signal (Z) fluctuant de manière aléatoire.

**8.** Procédé selon la revendication 7,
**caractérisé en ce que** l'on utilise un transmetteur de position (7) avec une caractéristique de transmetteur, laquelle est imprégnée de manière constructive par une variation dans le temps des perturbations de signal (Z) fluctuant exclusivement de manière aléatoire du signal de sortie (S) conformément à une superposition du signal primaire (SG) et d'un motif en particulier binaire et/ou segmenté via les pôles du transmetteur et/ou d'un pseudo signal de bruit, tel en particulier un bruit blanc.

**9.** Procédé selon les revendications 7 et 8,
**caractérisé en ce que** la première grandeur caractéristique d'évaluation ($F_\Phi$), laquelle est obtenue à partir de la variation dans le temps des perturbations de signal (Z) du signal de sortie (S) du transmetteur de position (7) en partant de la position de rotation de départ de référence (O), est obtenue en tant que quotient de la valeur maximale globale d'une fonction d'autocorrélation ($\Phi_{y,y}$) obtenue à partir de la séquence de signaux (y(i)) de la variation dans le temps du signal de sortie (S) du transmetteur de position (7) en partant de la position de rotation de départ de référence (O) et de la valeur maximale d'une fonction d'autocorrélation ($\Phi_{y,y}$) obtenue à partir de la séquence de signaux de la variation dans le temps du signal de sortie (S) avec des perturbations de signal (Z) fluctuant exclusivement de manière aléatoire.

**10.** Procédé selon l'une des revendications 1 à 9,
en particulier selon la revendication 9, **caractérisé en ce que**, lorsque la variation dans le temps des perturbations de signal (Z) du signal de sortie (S) actuel du transmetteur de position (7) diffère de manière significative d'un signal primaire de base avec des perturbations de signal (Z) fluctuant exclusivement de manière aléatoire, en particulier lorsque la première grandeur caractéristique d'évaluation ($F_\Phi$) adopte une valeur $\geq 1,1$, on choisit un premier type de procédué selon lequel on effectue respectivement la comparaison entre la variation dans le temps de la fraction des perturbations de signal (Z) fluctuant systématiquement du signal de sortie (S) actuel et la variation dans le temps de la fraction des perturbations de signal (Z) fluctuant systématiquement du signal de sortie (S) du transmetteur de position (7) dans la position de rotation de départ de référence (O).

**11.** Procédé selon l'une des revendications 1 à 10,
**caractérisé en ce que** l'on détermine, à partir de la séquence de signaux (x(i)) de la variation dans le temps des perturbations de signal (Z) du signal de sortie (S) du transmetteur de position (7) dans la position de rotation actuelle et à partir de la séquence de signaux (y(i)) de la variation dans le temps des perturbations de signal (Z) du signal de sortie (S) du transmetteur de position (7) en partant de la position de rotation de départ de référence (O), en particulier respectivement en tant qu'une valeur obtenue grâce à une transformation de Fourier, une fraction d'oscillation fondamentale, laquelle est caractéristique pour la variation dans le temps des perturbations de signal (Z) fluctuant systématiquement.

**12.** Procédé selon les revendications 6 et 11,
**caractérisé en ce qu'**une deuxième grandeur caractéristique d'évaluation ($F_1$), laquelle est obtenue à partir de la variation dans le temps des perturbations de signal (Z) du signal de sortie (S) du transmetteur de position (7) dans la position de rotation actuelle, est obtenue grâce à une comparaison entre la fraction d'oscillation fondamentale caractéristique pour les perturbations de signal (Z) fluctuant systématiquement et l'ampleur de toutes les fractions d'oscillation des perturbations de signal (Z).

**13.** Procédé selon la revendication 12,
**caractérisé en ce que** l'on tient compte en tant que valeur représentative pour l'ampleur de toutes les fractions d'oscillation, de la valeur de racine de la somme des carrés des valeurs de mesure (x(i)) de préférence soumises à une transformation de Fourier de la séquence de signaux (x(i)) de la variation dans le temps du signal de sortie (S) ou des perturbations de signal (Z) du signal de sortie (S) du transmetteur de position (7) dans la position de rotation actuelle.

**14.** Procédé selon l'une des revendications 1 à 13, en particulier selon la revendication 13,
**caractérisé en ce que**, lorsque la variation dans le temps des perturbations de signal (Z) du signal de sortie (S) actuel du transmetteur de position (7) présente une fraction d'oscillation fondamentale pour les perturbations de signal (Z) fluctuant systématiquement, laquelle diffère de manière significative de toutes les autres fractions d'oscillation des perturbations de signal (Z), en particulier lorsque la deuxième valeur caractéristique d'évaluation ($F_1$) adopte une valeur $\geq 0,5$, on choisit un second type de procédé selon lequel on procède respectivement à la comparaison entre la variation dans le temps de la fraction des perturbations de signal (Z) fluctuant systématiquement du signal de sortie (S) actuel et la variation dans le temps de la fraction des perturbations de signal (Z) fluctuant systématiquement du signal de sortie (S) du transmetteur de position (7) dans la position de rotation de départ de référence (O).

**15.** Procédé selon l'une des revendications précédentes,
**caractérisé en ce que**, lorsque ni la variation dans le temps des perturbations de signal (Z) du signal de sortie (S) actuel du transmetteur de position (7) ne diffère de manière significative d'un signal primaire de base avec des perturbations de signal (Z) fluctuant exclusivement de manière aléatoire dans le temps, en particulier lorsque la première valeur caractéristique d'évaluation ($F_\Phi$) adopte une valeur égale à 1, ni la variation dans le temps des perturbations de signal (Z) du signal de sortie (S) actuel du transmetteur de position (7) ne présente une fraction d'oscillation fondamentale pour les perturbations de signal (Z) fluctuant systématiquement, laquelle diffère de manière significative de toutes les autres fractions d'oscillation des perturbations de signal (Z), en particulier lorsque la deuxième valeur caractéristique d'évaluation ($F_1$) adopte une valeur inférieure à 0,5, il s'en suit une modification des conditions d'utilisation du transmetteur de position (7) incrémentiel et/ou du transmetteur de position (7) incrémentiel lui-même, telle un échange.

**16.** Procédé selon l'une des revendications 1 à 15,
**caractérisé en ce que**, d'après un/le premier type de procédé pour la comparaison de la variation dans le temps de la fraction des perturbations de signal (Z) fluctuant systématiquement des valeurs de mesure de la séquence de signaux (x(i)) actuelle avec la variation dans le temps de la fraction des perturbations de signal (Z) fluctuant systématiquement à partir des valeurs de mesure de la séquence de signaux (y(i)) obtenue en partant de la position de rotation de départ de référence (O), on réalise, à partir des valeurs de mesure de la séquence de signaux (x(i), y(i)), une fonction de corrélation croisée.

**17.** Procédé selon la revendication 16,
**caractérisé en ce que** la position de rotation de départ (A) actuelle est déterminée comme étant un décalage angulaire ($n_{z,offs}$) dans sa relation avec une position de rotation de départ de référence (O), lequel résulte de la valeur de l'abscisse du maximum de la fonction de corrélation croisée.

**18.** Procédé selon la revendication 17,
**caractérisé en ce que** les valeurs d'abscisse de la fonction de corrélation croisée des séquences de signaux (x(i), y(i)) sont formées par multiplication de la valeur d'un incrément temporel par un certain nombre d'incréments qui est associé à la valeur de mesure respective dans une séquence de signaux (x(i), y(i)).

**19.** Procédé selon l'une des revendications 1 à 18,
**caractérisé en ce que** l'on détermine, exclusivement à partir de la variation dans le temps de la séquence de signaux (x(i)) du signal de sortie (S) actuel du transmetteur de position (7), une vitesse angulaire actuelle du rotor.

**20.** Procédé selon l'une des revendications 17, 18 et 19,
**caractérisé en ce que** le décalage angulaire ($n_{z,offs}$) entre la position de rotation de départ actuelle (A) et la position de rotation de départ de référence (O) du rotor est déterminé en tant que produit de la vitesse angulaire du rotor et de la valeur de l'abscisse du maximum de la fonction de corrélation croisée.

**21.** Procédé selon la revendication 11,
**caractérisé en ce que**, d'après un/le second type de procédé pour la comparaison de la variation dans le temps de la fraction des perturbations de signal (Z) fluctuant systématiquement des valeurs de mesure de la séquence de signaux (x(i)) actuelle avec la variation dans le temps de la fraction des perturbations de signal (Z) fluctuant systématiquement à partir des valeurs de mesure de la séquence de signaux (y(i) obtenue en partant de la position de rotation de départ de référence (O), on détermine, à partir des valeurs de mesure des séquences de signaux (x(i), y(i)), en particulier après une transformation de Fourier des valeurs de mesure, la position de rotation de départ actuelle (A) dans son rapport avec une position de rotation de départ de référence en tant qu'un décalage angulaire ($n_{z,offs}$), qui résulte d'une différence des positions de phase des fractions d'oscillation fondamentale des séquences de signaux (x(i), y(i)).

**22.** Procédé selon l'une des revendications 1 à 21,
**caractérisé en ce que**, avant chaque traitement de signal, on compare le nombre de valeurs de mesure de la séquence de signaux (x(i)) actuelle du signal de sortie (S) du transmetteur de position (7) avec le nombre de valeurs de mesure de la séquence de signaux (y(i)) obtenue en partant de la position de rotation de départ de référence (O) du signal de sortie (S) du transmetteur de position (7), et **en ce que**, lorsque le nombre de valeurs de mesure de la séquence de signaux (x(i)) actuelle est plus grand que le nombre de valeurs de mesure de la séquence de signaux (y(i)) obtenue en partant de la position de rotation de départ de référence (O), on forme, grâce à un ajout simple ou multiple complètement et/ou partiellement répétitif des valeurs de mesure de la séquence de signaux (y(i)), à partir de la séquence de signaux (y(i)) obtenue en partant de la position de rotation de départ de référence (O), une séquence de signaux (y*(j)) ajustée avec le même nombre de valeurs de mesure que le nombre de valeurs de mesure de la séquence de signaux (x(i)) actuelle.

23. Procédé selon l'une des revendications 1 à 22,
**caractérisé en ce que** le nombre des incréments se situe dans la plage de 3000 à 100000 compte tenu d'une révolution complète du rotor (2).

24. Procédé selon l'une des revendications 1 à 23,
**caractérisé en ce que** l'on utilise, en guise de transmetteur de position (7) incrémentiel, un capteur inductif, magnétorésistif, optique ou de Hall.

25. Agencement pour la détection de l'état dynamique d'un moteur électrique (1), en particulier d'un petit servomoteur à courant continu sans balai, commuté électroniquement, de préférence pour la mise en oeuvre d'un procédé selon l'une des revendications 1 à 24, comprenant une commande de moteur (100) pour le moteur électrique (1), un transmetteur de position (7) incrémentiel et une unité de traitement de signaux (200), l'unité de traitement (200), laquelle sert à une détermination univoque de positions de rotation du rotor (2) au sein d'une révolution du rotor (2) du moteur électrique (1), à savoir d'une position de rotation actuelle ($\varphi_{ges}$) par rapport à une position de rotation de départ actuelle (A) ainsi que de cette position de rotation de départ actuelle (A) par rapport à une position de rotation de départ de référence (O), comprenant une unité pour la détermination d'une séquence de signaux (x(i), y(i)) caractéristique pour un signal (S) du transmetteur de position (7), une mémoire non volatile (ROM) pour au moins une séquence de références x(i) du signal (S) et deux unités pour la détermination respectivement d'une première grandeur caractéristique d'évaluation ($F_\Phi$) ou d'une deuxième grandeur caractéristique d'évaluation ($F_1$) pour les séquences de signaux (x(i), y(i)) ainsi que respectivement une unité associée à chaque unité pour la détermination des grandeurs caractéristiques d'évaluation ($F_\Phi$, $F_1$) pour la détermination d'un décalage angulaire ($n_{z,offs}$) de la position de rotation de départ actuelle (A) par rapport à la position de rotation de départ de référence (O) à partir de la comparaison entre une séquence de signaux x(i) actuelle et au moins une séquence de référence y(i) déposée dans la mémoire morte (ROM), les unités pour la détermination du décalage angulaire ($n_{z,offs}$) étant étudiées de manière à ce que la détermination du décalage angulaire ($n_{z,offs}$) s'effectue respectivement d'après différents types de procédés du traitement des signaux de la séquence de signaux x(i) actuelle.

26. Agencement selon la revendication 25,
**caractérisé par** des éléments constitutifs pour la réalisation des caractéristiques procédurales de la caractéristique distinctive d'une ou plusieurs des revendications 1 à 24.

Fig. 1

Fig. 2

**Fig. 3**

## Fig. 4

## Fig. 5

**Fig. 6**

**Fig. 7**

**Fig. 8**

**Fig. 9** $\phi_{x,x}(\phi_{y,y})$

**Fig. 10** $\phi_{x,x}(\phi_{y,y})$

**Fig. 11**

**Fig. 12**

**Fig. 13**

**Fig. 14**

## Fig. 15

$$n_{z,offs} = 9$$

arg ( Y(1))       arg ( Y(1))

## Fig. 16

Grundschwingungsanteil $F_1$ der Referenzfolge

Signifikanz der Korrelation $F_\Phi$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008010964
- DE 19815964 B4
- US 7800325 B2
- DE 102010031813 A1
- EP 1596493 A1
- JP 2011141207 B
- US 2007029955 A

**In der Beschreibung aufgeführte Nicht-Patentliteratur**

- **R. SCHWARZ et al.** Increasing Signal Accurancy of Automotive Wheel-Speed Sensors by On-line Learning. *Proceedings of the American Control Conference, Albuquerque, New Mexico,* Juni 1997, 1131-1135